(19) Europäisches Patentamt / European Patent Office / Office européen des brevets

(11) **EP 4 196 805 B1**

(12) **EUROPÄISCHE PATENTSCHRIFT**

(45) Veröffentlichungstag und Bekanntmachung des Hinweises auf die Patenterteilung:
**04.09.2024 Patentblatt 2024/36**

(21) Anmeldenummer: **21749774.2**

(22) Anmeldetag: **14.07.2021**

(51) Internationale Patentklassifikation (IPC):
**G01R 31/367** *(2019.01)* **G01R 31/392** *(2019.01)*
**G01R 31/396** *(2019.01)*

(52) Gemeinsame Patentklassifikation (CPC):
**G01R 31/392; G01R 31/367; G01R 31/396**

(86) Internationale Anmeldenummer:
**PCT/EP2021/069620**

(87) Internationale Veröffentlichungsnummer:
**WO 2022/033794 (17.02.2022 Gazette 2022/07)**

(54) **BATTERIEMANAGEMENTSYSTEM ZUM KLASSIFIZIEREN EINES BATTERIEMODULS**
BATTERY MANAGEMENT SYSTEM FOR CLASSIFYING A BATTERY MODULE
SYSTÈME DE GESTION DE BATTERIE POUR CLASSIFIER UN MODULE DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.08.2020 DE 102020121098**

(43) Veröffentlichungstag der Anmeldung:
**21.06.2023 Patentblatt 2023/25**

(73) Patentinhaber: **Lisa Dräxlmaier GmbH**
**84137 Vilsbiburg (DE)**

(72) Erfinder:
• HINTERBRANDNER, Florian
83471 Schönau am Königssee (DE)
• MEIER, Simon
81373 München (DE)
• OBERMAYER, Paul
80333 München (DE)

(56) Entgegenhaltungen:
DE-A1- 102016 200 289     US-A1- 2011 060 538
US-A1- 2016 169 978       US-B1- 6 526 361

EP 4 196 805 B1

**Beschreibung**

Die Erfindung betrifft ein Batteriemanagementsystem und ein Verfahren zum Klassifizieren eines Batteriemoduls mit Batteriezellen. Insbesondere betrifft die Erfindung Klassifizierungsalgorithmen zum automatischen Detektieren von Anomalien in dem Batteriemodul.

Batteriemodule deren Spannungsverlauf während einer Belastungsphase außerhalb der für den Zelltyp und Alterungszustand typischen Normalverteilung liegen, können derzeitig nur optisch von Fachpersonal erkannt werden. Dies ist mit erheblichem Zeitaufwand und Fehlerpotenzial aufgrund der sowohl manuellen als auch monotonen Tätigkeit verbunden.

Zur Optimierung des Herstellungsprozesses von Batteriesystemen ist die Bestimmung der erzielten Produktgüte unerlässlich. Dazu werden in modernen Fertigungsanlagen meist vollautomatisch Messdaten in digitaler Form erhoben. Für die Auswertung dieser Daten bietet sich die Verwendung von Machine Learning Methoden an, durch die eine kostengünstige und schnelle Vollprüfung möglich ist. Zudem weist das Machine Learning Modell - anders als der Mensch - keine Ermüdungserscheinungen aufgrund der monotonen Arbeit auf.

Die Druckschrift US 2016/169978 A1 betrifft eine Vorrichtung, ein Verfahren und ein nichtflüchtiges Aufzeichnungsmedium, auf dem ein Programm zum Identifizieren einer Position einer Anomalie gespeichert ist, die in einem Sekundärbatteriesystem mit zwei oder mehr Modulen, die jeweils einen oder mehrere Blöcke beherbergen, aufgetreten ist. Jeder der Blöcke wird durch die Verbindung von Batteriezellen aus zwei oder mehr Sekundärbatterien gebildet.

Die Druckschrift US 6 526 361 B1 beschreibt ein Verfahren und eine Vorrichtung zur Batteriebewertung und -klassifizierung, wobei vorübergehende Mikroladungs- und/oder Mikrolastimpulse auf eine Autobatterie angewendet werden. Die Klassifizierung erfolgt auf der Grundlage der Analyse des resultierenden Spannungsprofils oder von Teilen oder Abmessungen davon.

Es ist eine Aufgabe der vorliegenden Erfindung, ein Batteriemanagementsystem und ein Verfahren zum Klassifizieren von Batteriemodulen bereitzustellen, welche Anomalien in den Batteriemodulen detektieren und die Anomalien auf verschiedene Arten klassifizieren können. Insbesondere wird gezeigt, dass Machine Learning Methoden zur Detektion von Anomalien in Batteriesystemen geeignet sind.

Die Erfindung basiert auf der Idee, dass die Anomalien anhand von Spannungsverläufen der Batteriemodule sichtbar sind. So werden anhand der elektrischen Verschaltung eines Batteriemodels die Auswirkungen von fehlerhaften Innenwiderstandswerten, Kapazitätswerten und Offset-Spannungen hergeleitet. Es stellte sich heraus, dass alle beobachteten Effekte anhand der drei genannten physikalischen Größen beschrieben werden können. Auf Basis dieser Erkenntnis werden verschiedene Anomalietypen sowie ein Normalfall definiert.

Gemäß einem ersten Aspekt der Erfindung wird die Aufgabe gelöst durch ein Batteriemanagementsystem zum Klassifizieren eines Batteriemoduls, wobei das Batteriemodul eine erste Batteriezelle und eine zweite Batteriezelle aufweist. Das Batteriemanagementsystem umfasst eine Schnittstelle und einen Prozessor. Die Schnittstelle ist ausgebildet, einen ersten Spannungsverlauf über der ersten Batteriezelle und einen zweiten Spannungsverlauf über der zweiten Batteriezelle zu erhalten, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist.

Ferner ist der Prozessor ausgebildet: einen Referenzspannungsverlauf auf der Basis eines Spannungsmittelwertes aus dem ersten Spannungsverlauf und aus dem zweiten Spannungsverlauf zu bestimmen, wobei der Referenzspannungsverlauf einen ersten Referenzspannungsverlaufsabschnitt und einen zweiten Referenzspannungsverlaufsabschnitt aufweist; den ersten Spannungsverlauf mit dem Referenzspannungsverlauf zu vergleichen, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt; den zweiten Spannungsverlauf mit dem Referenzspannungsverlauf zu vergleichen, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt; dem ersten Spannungsverlaufsabschnitt eine erste elektrische Charakteristik zuzuordnen und dem zweiten Spannungsverlaufsabschnitt eine zweite elektrische Charakteristik zuzuordnen, falls die erste Metrik größer als die zweite Metrik ist, um das Batteriemodul durch die erste elektrische Charakteristik und die zweite elektrische Charakteristik zu klassifizieren; oder dem dritten Spannungsverlaufsabschnitt eine dritte elektrische Charakteristik zuzuordnen und dem vierten Spannungsverlaufsabschnitt eine vierte elektrische Charakteristik zuzuordnen, falls die erste Metrik kleiner als die zweite Metrik ist, um das Batteriemodul durch die dritte elektrische Charakteristik und die vierte elektrische Charakteristik zu klassifizieren.

Damit wird der technische Vorteil erreicht, dass Anomalien in den Batteriemodulen detektiert werden, wodurch eine Unterscheidung zwischen fehlerfreien Batteriemodulen (d.h. Normalfällen) und fehlerbehafteten Batteriemodulen ermöglicht wird.

Gemäß einer beispielhaften Ausführungsform des Batteriemanagementsystems umfasst das Batteriemanagementsystem einen Speicher, welcher ausgebildet ist, eine Mehrzahl von elektrischen Charakteristika zu speichern, wobei der Prozessor ausgebildet ist, die jeweilige elektrische Charakteristik aus dem Speicher auszulesen.

Dadurch können die elektrischen Charakteristiken gespeichert und ausgelesen werden.

Gemäß einer beispielhaften Ausführungsform des Batteriemanagementsystems ist der Prozessor ausgebildet, den Referenzspannungsverlauf auf der Basis von dem ersten Spannungsverlauf und dem zweiten Spannungsverlauf zu bestimmen.

Damit wird der technische Vorteil erreicht, dass ein Referenzspannungsverlauf für ein Batteriemodul effizient berechnet wird.

Gemäß einer beispielhaften Ausführungsform des Batteriemanagementsystems umfasst der Referenzspannungsverlauf einen Median oder einen Durchschnitt aus dem ersten Spannungsverlauf und aus dem zweiten Spannungsverlauf.

Damit wird der technische Vorteil erreicht, dass ein Referenzspannungsverlauf für ein Batteriemodul effizient berechnet wird.

Gemäß einer beispielhaften Ausführungsform des Batteriemanagementsystems weist das Batteriemodul eine dritte Batteriezelle auf und die Schnittstelle ist ausgebildet, einen dritten Spannungsverlauf über der dritten Batteriezelle zu erhalten, wobei der Prozessor ausgebildet ist, den Referenzspannungsverlauf auf der Basis von dem ersten Spannungsverlauf, dem zweiten Spannungsverlauf und dem dritten Spannungsverlauf zu bestimmen.

Gemäß einer beispielhaften Ausführungsform des Batteriemanagementsystems umfasst der Referenzspannungsverlauf einen Median, einen Durchschnitt oder einen Modus aus dem ersten Spannungsverlauf, dem zweiten Spannungsverlauf und dem dritten Spannungsverlauf.

Damit wird der technische Vorteil erreicht, dass ein Referenzspannungsverlauf für ein Batteriemodul erzeugt wird, welcher zum Detektieren derjenigen Batteriezelle dient, welche sich bezüglich des Spannungsverlaufs am meisten von den anderen Batteriezellen des Batteriemoduls unterscheidet.

Gemäß einer beispielhaften Ausführungsform des Batteriemanagementsystems ist der Prozessor ausgebildet: die erste elektrische Charakteristik auf der Basis des ersten Spannungsverlaufsabschnitts des ersten Spannungsverlaufs und die zweite elektrische Charakteristik auf der Basis des zweiten Spannungsverlaufsabschnitts des ersten Spannungsverlaufs mittels einer Hauptkomponentenanalyse zu bestimmen, wobei die erste elektrische Charakteristik den ersten Spannungsverlaufsabschnitt des ersten Spannungsverlaufs repräsentiert und die zweite elektrische Charakteristik den zweiten Spannungsverlaufsabschnitt des ersten Spannungsverlaufs repräsentiert; und/oder die dritte elektrische Charakteristik auf der Basis des dritten Spannungsverlaufsabschnitts des zweiten Spannungsverlaufs und die vierte elektrische Charakteristik auf der Basis des vierten Spannungsverlaufsabschnitts des zweiten Spannungsverlaufs mittels der Hauptkomponentenanalyse zu bestimmen, wobei die dritte elektrische Charakteristik den dritten Spannungsverlaufsabschnitt des zweiten Spannungsverlaufs repräsentiert und die vierte elektrische Charakteristik den vierten Spannungsverlaufsabschnitt des zweiten Spannungsverlaufs repräsentiert.

Dadurch können die elektrischen Charakteristiken effizient bestimmt werden.

Gemäß einer beispielhaften Ausführungsform des Batteriemanagementsystems ist der Prozessor ausgebildet, ein erstes elektrisches Merkmal auf der Basis des ersten Spannungsverlaufsabschnitts des ersten Spannungsverlaufs, ein zweites elektrisches Merkmal auf der Basis des zweiten Spannungsverlaufsabschnitts des ersten Spannungsverlaufs, ein drittes elektrisches Merkmal auf der Basis des dritten Spannungsverlaufsabschnitts des zweiten Spannungsverlaufs, ein viertes elektrisches Merkmal auf der Basis des vierten Spannungsverlaufsabschnitts des zweiten Spannungsverlaufs zu bestimmen.

Gemäß einer beispielhaften Ausführungsform des Batteriemanagementsystems entspricht das erste elektrische Merkmal einer Offset-Spannung der ersten Batteriezelle und das dritte elektrische Merkmal entspricht einer weiteren Offset-Spannung der zweiten Batteriezelle, wobei das zweite elektrische Merkmal einem Innenwiderstand der ersten Batteriezelle entspricht und das vierte elektrische Merkmal einem weiteren Innenwiderstand der zweiten Batteriezelle entspricht.

Damit wird der technische Vorteil erreicht, dass die elektrischen Merkmale von Batteriezellen eines Batteriemoduls effizient extrahiert werden, wodurch eine auftretende Anomalie in dem Batteriemodul mithilfe der Offset-Spannung und des Innenwiderstandes einer jeweiligen Batteriezelle beschrieben werden kann.

Gemäß einer beispielhaften Ausführungsform des Batteriemanagementsystems ist der Prozessor ausgebildet, das Batteriemodul mittels eines Klassifizierungsalgorithmus zu klassifizieren, wobei der Klassifizierungsalgorithmus mindestens einen von logistischer Regression, Support Vector Machine, Random Forest, mehrschichtigem Perzeptron und One-Class Support Vector Machine umfasst.

Damit wird der technische Vorteil erreicht, dass ein Batteriemodul effizient klassifiziert wird, um das Batteriemodul als fehlerfrei oder fehlerbehaftet zu bestimmen.

Gemäß einer beispielhaften Ausführungsform des Batteriemanagementsystems ist die Schnittstelle ausgebildet, eine erste Mehrzahl von Spannungsverläufen und eine zweite Mehrzahl von Spannungsverläufen zu erhalten, wobei jeder der ersten Mehrzahl von Spannungsverläufen einer ersten Batteriezelle eines einer Mehrzahl von Batteriemodulen entspricht und jeder der zweiten Mehrzahl von Spannungsverläufen einer zweiten Batteriezelle eines der Mehrzahl von Batteriemodulen entspricht, wobei die Schnittstelle ausgebildet ist, die Mehrzahl von Batteriemodulen als fehlerfrei zu handhaben, wobei der Prozessor ausgebildet ist, jedes Batteriemodul der Mehrzahl von Batteriemodulen mittels eines weiteren Klassifizierungsalgorithmus zu klassifizieren, um auf der Basis der Klassifizierung eine Referenzgruppe zu bilden.

Damit wird der technische Vorteil erreicht, dass eine Referenzgruppe von fehlerfreien Batteriemodulen effizient gebildet wird und eine strikte Grenze für fehlerfreie Batteriemodule im Merkmalsraum festgelegt wird, wodurch die Batteriemodule, die außerhalb dieser Grenze liegen, als Anomalien deklariert werden können.

Gemäß einer beispielhaften Ausführungsform des Batteriemanagementsystems ist der Prozessor ausgebildet, die Mehrzahl von Batteriemodulen mittels eines weiteren Klassifizierungsalgorithmus zu klassifizieren, wobei der weitere Klassifizierungsalgorithmus mindestens einen von logistischer Regression, Support Vector Machine, Random Forest, mehrschichtigem Perzeptron, und One-Class Support Vector Machine umfasst.

Damit wird der technische Vorteil erreicht, dass eine Referenzgruppe von fehlerfreien Batteriemodulen effizient gebildet wird und eine strikte Grenze für fehlerfreie Batteriemodule im Merkmalsraum festgelegt wird.

Gemäß einer beispielhaften Ausführungsform des Batteriemanagementsystems weist der erste Spannungsverlauf einen fünften Spannungsverlaufsabschnitt auf und der zweite Spannungsverlauf weist einen sechsten Spannungsverlaufsabschnitt auf, wobei der Prozessor ausgebildet ist, ein fünftes Merkmal auf der Basis des fünften Spannungsverlaufsabschnitts des ersten Spannungsverlaufs und ein sechstes Merkmal auf der Basis des sechsten Spannungsverlaufsabschnitts des zweiten Spannungsverlaufs zu extrahieren.

Gemäß einer beispielhaften Ausführungsform des Batteriemanagementsystems entspricht das fünfte Merkmal einer Kapazität der ersten Batteriezelle und das sechste Merkmal entspricht einer weiteren Kapazität der zweiten Batteriezelle.

Damit wird der technische Vorteil erreicht, dass die elektrischen Merkmale von Batteriezellen eines Batteriemoduls effizient extrahiert werden, wodurch eine auftretende Anomalie in dem Batteriemodul mithilfe der Offset-Spannung, der Zellkapazität und/oder des Innenwiderstandes einer jeweiligen Batteriezelle beschrieben werden kann.

Gemäß einer beispielhaften Ausführungsform des Batteriemanagementsystems ist die Schnittstelle ausgebildet, eine Anzahl an zu erzeugenden Gruppen, eine weitere erste Mehrzahl von Spannungsverläufen und eine weitere zweite Mehrzahl von Spannungsverläufen zu erhalten, wobei jeder der weiteren ersten Mehrzahl von Spannungsverläufen einer ersten Batteriezelle eines einer weiteren Mehrzahl von Batteriemodulen entspricht und wobei jeder der weiteren zweiten Mehrzahl von Spannungsverläufen einer zweiten Batteriezelle eines der weiteren Mehrzahl von Batteriemodulen entspricht, wobei der Prozessor ausgebildet ist, jedes Batteriemodul der weiteren Mehrzahl von Batteriemodulen mittels des Klassifizierungsalgorithmus einer Mehrzahl von Gruppen zuzuordnen, wobei die Menge der Mehrzahl von Gruppen gleich mit der Anzahl an zu erzeugenden Gruppen ist.

Damit wird der technische Vorteil erreicht, dass die Batteriemodule effizient klassifiziert werden, wodurch die Anomalien in den Batteriemodulen detektiert und die Anomalien auf verschiedene Arten klassifiziert werden.

Die Aufgabe wird gemäß einem zweiten Aspekt der Erfindung durch ein Verfahren zum Batteriemanagement gelöst, umfassend die folgenden Verfahrensschritte: Erhalten eines ersten Spannungsverlaufs über einer ersten Batteriezelle eines Batteriemoduls und eines zweiten Spannungsverlaufs über einer zweiten Batteriezelle des Batteriemoduls, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist; Bestimmen eines Referenzspannungsverlaufs auf der Basis eines Spannungsmittelwertes aus dem ersten Spannungsverlauf und aus dem zweiten Spannungsverlauf, wobei der Referenzspannungsverlauf einen ersten Referenzspannungsverlaufsabschnitt und einen zweiten Referenzspannungsverlaufsabschnitt aufweist; Vergleichen des ersten Spannungsverlaufs mit dem Referenzspannungsverlauf, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt; Vergleichen des zweiten Spannungsverlaufs mit dem Referenzspannungsverlauf, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt; Zuordnen einer ersten elektrischen Charakteristik dem ersten Spannungsverlaufsabschnitt und einer zweiten elektrischen Charakteristik dem zweiten Spannungsverlaufsabschnitt, falls die erste Metrik größer als die zweite Metrik ist, um das Batteriemodul durch die erste elektrische Charakteristik und die zweite elektrische Charakteristik zu klassifizieren; oder Zuordnen einer dritten elektrischen Charakteristik dem dritten Spannungsverlaufsabschnitt und einer vierten elektrischen Charakteristik dem vierten Spannungsverlaufsabschnitt, falls die erste Metrik kleiner als die zweite Metrik ist, um das Batteriemodul durch die dritte elektrische Charakteristik und die vierte elektrische Charakteristik zu klassifizieren.

Damit wird der technische Vorteil erreicht, dass Anomalien in den Batteriemodulen detektiert werden, wodurch eine Unterscheidung zwischen fehlerfreien Batteriemodulen (d.h. Normalfällen) und fehlerbehafteten Batteriemodulen ermöglicht wird.

Alle in Bezug auf das Batteriemanagementsystem gemäß dem ersten Aspekt angeführten Ausführungsformen gelten ebenso als Ausführungsformen für das Verfahren gemäß dem zweiten Aspekt.

Im Folgenden wird die Erfindung anhand von Ausführungsbeispielen und den Figuren näher beschrieben. In den Figuren zeigen:

Fig. 1    eine schematische Darstellung eines Batteriemanagementsystems gemäß einem Ausführungsbeispiel zum Klassifizieren eines Batteriemoduls;

Fig. 2    eine Tabelle der definierten Anomalietypen gemäß einem Ausführungsbeispiel;

Fig. 3    ein Beispiel für günstig und ungünstig gewählte Parametereinstellungen;

Fig. 4    ein Beispiel eines Spannungsverlaufs und Interpolation des Signals;

Fig. 5    ein Beispiel für ein Signal mit einem untypischen Signalverlauf;

Fig. 6    ein diskreten-Wavelet-Transformation (DWT)-transformiertes Signal aus dem Beispiel der Fig. 5 und den qualitativen Verlauf einer abschnittsweise linearen Kostenfunktion;

Fig. 7    ein Beispiel der Segmentierung eines Spannungsverlaufs;

Fig. 8    simulierte Spannungsverläufe eines Batteriemoduls mit einer fehlerbehafteten Batteriezelle in einer Ausführungsform;

Fig. 9    ein Beispiel der aus einem Trainingsdatensatz erzeugten Feature-Vektoren;

Fig. 10    eine Tabelle der Ergebnisse der verschiedenen Klassifizierungsalgorithmen beim Training in einer Ausführungsform; und

Fig. 11    ein Flussdiagramm für ein Verfahren gemäß einem Ausführungsbeispiel.

In der folgenden ausführlichen Beschreibung wird auf die beiliegenden Figuren Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen der vorliegenden Erfindung werden unter Bezugnahme auf die Figuren beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der vorliegenden Erfindung zu vermitteln.

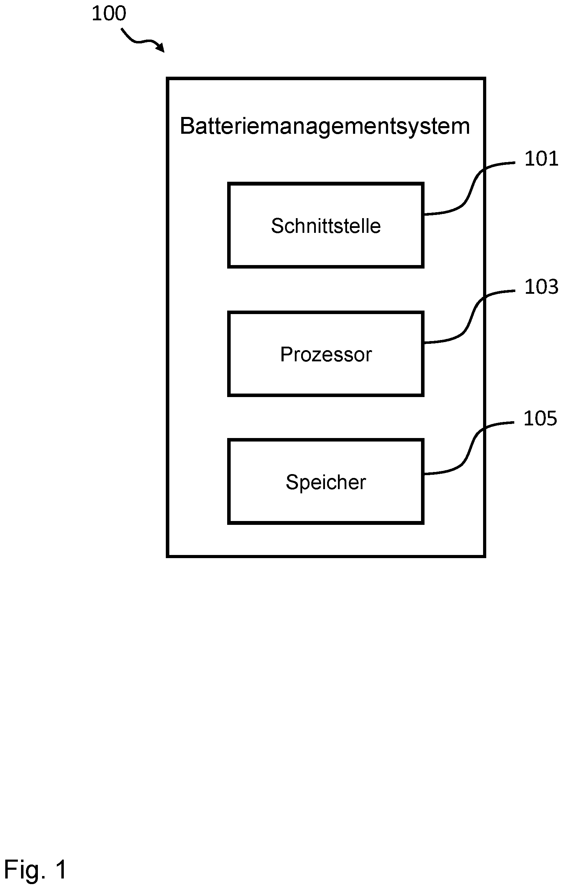

Fig. 1 zeigt eine schematische Darstellung eines Batteriemanagementsystems 100 zum Klassifizieren eines Batteriemoduls gemäß einem Ausführungsbeispiel, wobei das Batteriemodul mindestens eine erste Batteriezelle und eine zweite Batteriezelle aufweist. Wie in der Fig. 1 dargestellt, umfasst das Batteriemanagementsystem 100 eine Schnittstelle 101, einen Prozessor 103 und einen Speicher 105, deren Funktionalitäten im Folgenden näher betrachtet werden.

In einer Ausführungsform ist die Schnittstelle 101 ausgebildet, einen ersten Spannungsverlauf über der ersten Batteriezelle und einen zweiten Spannungsverlauf über der zweiten Batteriezelle zu erhalten, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist.

In einer Ausführungsform ist der Prozessor 103 ausgebildet, einen Referenzspannungsverlauf auf der Basis eines Spannungsmittelwertes aus dem ersten Spannungsverlauf und aus dem zweiten Spannungsverlauf zu bestimmen, wobei der Referenzspannungsverlauf einen ersten Referenzspannungsverlaufsabschnitt und einen zweiten Referenzspannungsverlaufsabschnitt aufweist. In einer Ausführungsform ist der Prozessor 105 ausgebildet, den Referenzspannungsverlauf auf der Basis von dem ersten Spannungsverlauf und dem zweiten Spannungsverlauf zu bestimmen und der Referenzspannungsverlauf umfasst einen Median oder einen Durchschnitt aus dem ersten Spannungsverlauf und aus dem zweiten Spannungsverlauf.

Ferner ist der Prozessor 103 ausgebildet, den ersten Spannungsverlauf mit dem Referenzspannungsverlauf zu vergleichen, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt; und den zweiten Spannungsverlauf mit dem Referenzspannungsverlauf zu vergleichen, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt.

Falls die erste Metrik größer als die zweite Metrik ist, ist der Prozessor 103 ausgebildet, dem ersten Spannungsverlaufsabschnitt eine erste elektrische Charakteristik zuzuordnen und dem zweiten Spannungsverlaufsabschnitt eine zweite elektrische Charakteristik zuzuordnen, um das Batteriemodul durch die erste elektrische Charakteristik und die zweite elektrische Charakteristik zu klassifizieren.

In einer Ausführungsform ist der Prozessor 103 ausgebildet: die erste elektrische Charakteristik auf der Basis des ersten Spannungsverlaufsabschnitts des ersten Spannungsverlaufs und die zweite elektrische Charakteristik auf der Basis des zweiten Spannungsverlaufsabschnitts des ersten Spannungsverlaufs mittels einer Hauptkomponentenanalyse zu bestimmen, wobei die erste elektrische Charakteristik den ersten Spannungsverlaufsabschnitt des ersten Spannungsverlaufs repräsentiert und die zweite elektrische Charakteristik den zweiten Spannungsverlaufsabschnitt des ersten Spannungsverlaufs repräsentiert.

Alternativ ist der Prozessor 103 ausgebildet, dem dritten Spannungsverlaufsabschnitt eine dritte elektrische Charakteristik zuzuordnen und dem vierten Spannungsverlaufsabschnitt eine vierte elektrische Charakteristik zuzuordnen, falls die erste Metrik kleiner als die zweite Metrik ist, um das Batteriemodul durch die dritte elektrische Charakteristik und die vierte elektrische Charakteristik zu klassifizieren.

In einer Ausführungsform ist der Prozessor 103 ausgebildet, die dritte elektrische Charakteristik auf der Basis des dritten Spannungsverlaufsabschnitts des zweiten Spannungsverlaufs und die vierte elektrische Charakteristik auf der Basis des vierten Spannungsverlaufsabschnitts des zweiten Spannungsverlaufs mittels der Hauptkomponentenanalyse zu bestimmen, wobei die dritte elektrische Charakteristik den dritten Spannungsverlaufsabschnitt des zweiten Spannungsverlaufs repräsentiert und die vierte elektrische Charakteristik den vierten Spannungsverlaufsabschnitt des zweiten Spannungsverlaufs repräsentiert.

In einer Ausführungsform ist der Speicher 105 ausgebildet, eine Mehrzahl von elektrischen Charakteristika zu speichern, wobei der Prozessor 103 ausgebildet ist, die jeweilige elektrische Charakteristik aus dem Speicher auszulesen.

Hinsichtlich der Klassifizierung ist der Prozessor 103 ausgebildet, das Batteriemodul mittels eines Klassifizierungsalgorithmus zu klassifizieren, wobei der Klassifizierungsalgorithmus mindestens einen von logistischer Regression, Support Vector Machine, Random Forest, mehrschichtigem Perzeptron, und One-Class Support Vector Machine umfasst.

In einer Ausführungsform weist das Batteriemodul ferner eine dritte Batteriezelle auf und die Schnittstelle 101 ist ausgebildet, einen dritten Spannungsverlauf über der dritten Batteriezelle zu erhalten, wobei der Prozessor 103 ausgebildet ist, den Referenzspannungsverlauf auf der Basis des ersten Spannungsverlaufs, des zweiten Spannungsverlaufs und des dritten Spannungsverlaufs zu bestimmen. In diesem Fall umfasst der Referenzspannungsverlauf einen Median, einen Durchschnitt oder einen Modus aus dem ersten Spannungsverlauf, dem zweiten Spannungsverlauf und dem dritten Spannungsverlauf.

In einer Ausführungsform ist der Prozessor ausgebildet, ein erstes elektrisches Merkmal auf der Basis des ersten Spannungsverlaufsabschnitts des ersten Spannungsverlaufs, ein zweites elektrisches Merkmal auf der Basis des zweiten Spannungsverlaufsabschnitts des ersten Spannungsverlaufs, ein drittes elektrisches Merkmal auf der Basis des dritten Spannungsverlaufsabschnitts des zweiten Spannungsverlaufs, ein viertes elektrisches Merkmal auf der Basis des vierten Spannungsverlaufsabschnitts des zweiten Spannungsverlaufs zu bestimmen, wobei das erste elektrische Merkmal einer Offset-Spannung der ersten Batteriezelle entspricht und das dritte elektrische Merkmal einer weiteren Offset-Spannung der zweiten Batteriezelle entspricht, wobei das zweite elektrische Merkmal einem Innenwiderstand der ersten Batteriezelle entspricht und das vierte elektrische Merkmal einem weiteren Innenwiderstand der zweiten Batteriezelle entspricht.

In einer Ausführungsform ist die Schnittstelle 101 ausgebildet, eine erste Mehrzahl von Spannungsverläufen und eine zweite Mehrzahl von Spannungsverläufen zu erhalten, wobei jeder der ersten Mehrzahl von Spannungsverläufen einer ersten Batteriezelle eines einer Mehrzahl von Batteriemodulen entspricht und jeder der zweiten Mehrzahl von Spannungsverläufen einer zweiten Batteriezelle eines der Mehrzahl von Batteriemodulen entspricht, wobei die Schnittstelle ausgebildet ist, die Mehrzahl von Batteriemodulen als fehlerfrei zu handhaben.

In diesem Fall ist der Prozessor 103 ausgebildet, jedes Batteriemodul der Mehrzahl von Batteriemodulen mittels eines weiteren Klassifizierungsalgorithmus zu klassifizieren, um auf der Basis der Klassifizierung eine Referenzgruppe zu bilden, wobei der weitere Klassifizierungsalgorithmus mindestens einen von logistischer Regression, Support Vector Machine, Random Forest, mehrschichtigem Perzeptron, One-Class Support Vector Machine umfasst.

In einer Ausführungsform weist der erste Spannungsverlauf einen fünften Spannungsverlaufsabschnitt auf und der zweite Spannungsverlauf weist einen sechsten Spannungsverlaufsabschnitt auf, wobei der Prozessor 103 ausgebildet ist, ein fünftes Merkmal auf der Basis des fünften Spannungsverlaufsabschnitts des ersten Spannungsverlaufs und ein sechstes Merkmal auf der Basis des sechsten Spannungsverlaufsabschnitts des zweiten Spannungsverlaufs zu extrahieren. Das fünfte Merkmal entspricht einer Kapazität der ersten Batteriezelle und das sechste Merkmal entspricht einer weiteren Kapazität der zweiten Batteriezelle.

In einer Ausführungsform ist die Schnittstelle 101 ferner ausgebildet, eine Anzahl an zu erzeugenden Gruppen, eine weitere erste Mehrzahl von Spannungsverläufen und eine weitere zweite Mehrzahl von Spannungsverläufen zu erhalten, wobei jeder der weiteren ersten Mehrzahl von Spannungsverläufen einer ersten Batteriezelle eines einer weiteren Mehrzahl von Batteriemodulen entspricht und wobei jeder der weiteren zweiten Mehrzahl von Spannungsverläufen einer zweiten Batteriezelle eines der weiteren Mehrzahl von Batteriemodulen entspricht. Entsprechend ist der Prozessor 103 ausgebildet, jedes Batteriemodul der weiteren Mehrzahl von Batteriemodulen mittels des Klassifizierungsalgorithmus einer Mehrzahl von Gruppen zuzuordnen, wobei die Menge der Mehrzahl von Gruppen gleich mit der Anzahl an zu erzeugenden Gruppen ist.

Durch die Ausführungsformen der vorliegenden Erfindung können vollautomatisch Batteriemodule hinsichtlich ihres Verhaltens analysiert und mögliche Anomalien erkannt und kategorisiert werden.

Damit werden die folgenden Vorteile erreicht:

- Kostenersparnis, da mögliche Reklamationen frühzeitig (unmittelbar nach der Fertigung) verhindert werden können
- Verfahren auf individuellen Batteriemodulen anwendbar
- Lokalisierung der betroffenen Module
- Kategorisierung der Anomalien (Indiz für Ursachen)
- 100% Prüfung aller Module

Die Ausführungsformen der vorliegenden Erfindung betreffen folgende Aspekte: Batteriesimulation, Erfassen von Ausreißern und Extrahieren von Merkmalen, Klassifizierungsalgorithmen und Anomalie-Detektion, welche im Folgenden näher betrachtet werden.

Mithilfe eines Batteriesimulationsmodells werden reale Anomalietypen nachgebildet und in gleichmäßiger Verteilung generiert. Eine anschließende Datenvorverarbeitung extrahiert die für die spätere Kategorisierung notwendigen Merkmale (Feature-Vektoren) und erkennt artfremde bzw. bislang unbekannte Anomalien (Ausreißer). Ein Klassifizierungsmodell ordnet jedes Modul einer bekannten Gruppe zu (es kategorisiert), wobei durch einen nachgelagerten Anomalie-Detektor die Entscheidungen, ob es sich um eine Anomalie handelt, noch kritischer betrachtet wird. Jedoch erfolgt in diesen Fällen eine rein binäre Zuordnung (Anomalie- oder Normal-Fall).

Ziel der Simulation von Anomalien ist es die Veränderung des physikalischen Verhaltens in Bezug zu dessen "normalen" Verhaltens zu erhalten und dieses veränderte Verhalten in dessen Ausprägung wiederholt nachbilden zu können. Dies muss in den Grenzen passieren, in denen diese Anomalie auftritt, um der Anomalie eine Ursache zuordnen zu können.

Um die benötigte Genauigkeit dieses veränderten Verhaltens sicher generieren zu können, sind drei Schritte erforderlich, die im Folgenden noch genau betrachtet werden:

- Verhalten des physikalischen Systems nachbilden
- Definieren der Parameter die Anomalien hervorrufen
- Verteilung von Parameter generieren

**Verhalten des physikalischen Systems nachbilden**

Das Verhalten des realen physikalischen Systems muss, in Bezug auf die zu analysierende Größe, möglichst exakt durch ein Simulationsmodell nachgebildet werden. Dies geschieht indem Parameter des Simulationsmodells so angepasst werden, dass die Abweichung von reales zu simulierten Verhalten möglichst minimal wird.

Diese Anpassung geschieht über eine Kombination von Optimierungsalgorithmen, die über eine definierte Reihenfolge eingesetzt werden. Diese ermitteln die Parameterkombination, die die geringste Abweichung der Simulation zu den realen Messungen aufweist. Dabei liegt dieser Parameteranpassung immer ein bereits initial an das allgemeine Verhalten angepasstes Parameterset zugrunde. Nach dieser Anpassung wird auch von einem "digitalen Zwilling" gesprochen, dass das Verhalten eines bestimmten, realen Systems wiederspiegelt.

## Definieren der Parameter die Anomalien hervorrufen

Um Anomalien gezielt erzeugen zu können müssen die Parameter ermittelt werden, die diese hervorrufen. Diese Zuweisung kann über reine Datenauswertung oder über den Fachbereich geschehen, der Verhaltensmuster Ursachen somit Parametern zuordnen kann. Es wurden drei Parameter definiert, die Anomalien charakterisieren können. Alle möglichen Kombinationen dieser Parameter legen die unten gezeigten Fälle fest.

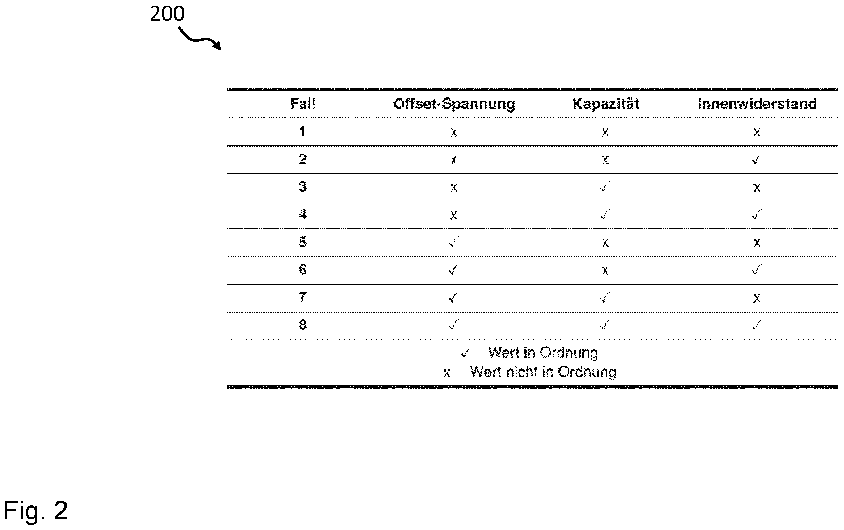

Fig. 2 zeigt eine Tabelle 200 der definierten Anomalietypen in einer Ausführungsform. Wie aus der Fig. 2 ersichtlich ist, können alle auftretenden Anomalien mithilfe der Offset-Spannung, der Zellkapazität und des Innenwiderstandes beschrieben werden.

## Anomalie-Verteilung generieren

Durch Analyse von vielen realen Anomaliefällen können die Ausprägungen der Parameter ermittelt werden die Anomalien hervorrufen. Diese Ausprägungen an Parametern dienen als Größenordnung um Parametergrenzen für bestimmte Anomalien zu erhalten.

Diese ermittelten Grenzen können nun genutzt werden, um eigenständig Anomalien zu erzeugen, die in ihrem Verhalten und Ausprägung denen realer Systeme entsprechen. Die erzeugten Anomaliefälle können beliebig oft und in jeder Kombination und Ausprägung erstellt und damit Machine Learning Algorithmen trainiert werden.

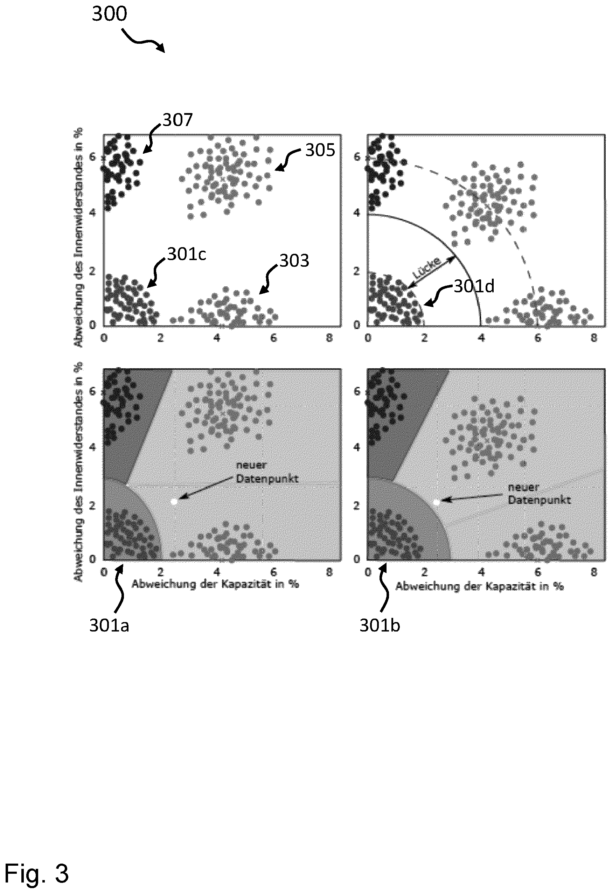

Die Erzeugung von Trainingsdatensätzen mithilfe eines Simulationsmodells bringt neben zahlreichen Vorteilen auch Herausforderungen mit sich. So ist die Wahl der Simulationsparameter essentiell für den späteren Gebrauch des trainierten Modells mit Realdaten. Es besteht beispielsweise die Gefahr, dass im Trainingsdatensatz die Parameter ungünstig gewählt werden, sodass bestimmte Fälle bevorzugt eintreten. Fig. 3 zeigt ein Beispiel für günstig *(rechts oben)* und ungünstig *(links oben)* gewählte Parametereinstellungen.

Aus Fig. 3 oben links ist ersichtlich, dass zwischen Normalfall 301c und reinem Kapazitätsfehler 303 ein sehr geringer Abstand besteht, wohingegen die beiden anderen Anomaliefälle 305,307 eine größere Distanz zum Normalfall aufweisen. Unterhalb sind beispielhafte Entscheidungsgrenzen, welche von einem Klassifizierer anhand der Trainingsdaten definiert werden, dargestellt. Der Klassifizierer würde einen neuen Datenpunkt, der sowohl beim Innenwiderstand als auch bei der Kapazität Auffälligkeiten aufweist, der Gruppe der Kapazitätsfehler zuordnen, da aufgrund der Trainingsdaten ungünstige Entscheidungsgrenzen festgelegt wurden. Abhilfe verschafft eine geschickte Anordnung der Parameter (siehe Fig. 3 rechts oben). Da alle Zentren der abnormalen Datenpunkte auf einem Kreisbogen liegen, besitzen diese einen identischen Abstand zum Zentrum der Normalfälle. Es wird folglich kein Fall künstlich bevorzugt und eine korrekte Klassifizierung (siehe Fig. 3 unten rechts) ist möglich.

Aus der Fig. 3 ist ferner ersichtlich, dass für das Trainieren von Klassifizierungsalgorithmen entscheidend ist, in diesen Anwendungsfall die Verteilung der Parameter kreisförmig um den Normalfall 301a-d erstellen zu lassen. Dabei werden die Parameter und ihre Kombinationen zu erstellt, dass jeweils eine Lücke zwischen den Fällen herrschen. Dies garantiert eine Abgrenzung der einzelnen Anomalien untereinander. Beispielhaft hier in zweidimensionalen Raum dargestellt mit zwei Parametern. Dieser Zusammenhang muss jedoch auch für höherdimensionale Beziehungen eingehalten werden. Die kreisförmige Anordnung um den Normalfall stellt dabei sicher, dass die erstellten Anomalien in ihrer Gewichtung gleichmäßig beurteilt werden, ebenso werden dazu Normalfälle und Anomalien in gleicher Anzahl erzeugt.

Bevor Machine Learning Methoden zum Erkennen und Klassifizieren von Anomalien herangezogen werden können ist eine aufwendige Datenvorverarbeitung notwendig. Diese erfolgt über mehrere Prozessschritte, welche nachfolgend aufgeführt werden.

## Zeitreihen filtern

In einer Ausführungsform bestehen die zu untersuchenden Batterien entweder aus 28 oder 33 Modulen. Unabhängig vom Batterietyp werden jedoch Daten für 33 Module aufgezeichnet. Handelt es sich um eine Batterie mit nur 28, so werden für die verbleibenden fünf Module Default-Werte verwendet. Das Entfernen dieser Module mit deren Default-Werten aus dem Realdatensatz bildet den ersten Schritt der Datenvorverarbeitung. Um die betroffenen Module identifizieren zu können, werden die einzelnen Zellspannungen ausgelesen. Besitzt ein Modul ausschließlich Default-Werte als Zellspannungen und ist die Modulnummer größer als 28, so wird dieses Modul mit den zugehörigen Zeitreihen gelöscht.

## Triggerpunkt bestimmen

Neben unterschiedlichen Längen von Zeitreihen, können Realdaten auch zeitlich versetzte Signale beinhalten.

Der Zeitversatz wird durch Triggern auf eine markante Flanke des Signals kompensiert. Zur dynamischen Detektion dieser Flanke dienen die erste Ableitung des Signals und eine vorab definierte Triggergrenze. Ist der Betrag der Steigung größer als diese Triggergrenze, so handelt es sich um die gesuchte Flanke.

**Zeitreihen interpolieren**

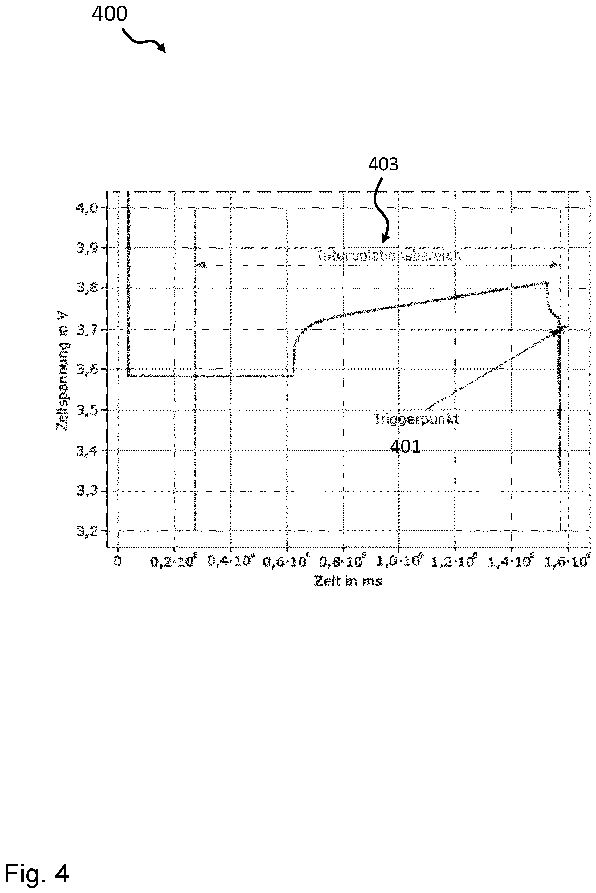

Die verwendeten Realdaten besitzen innerhalb einer Zeitreihe unterschiedliche Schrittweiten. Betrachtet man das Signal ohne die korrespondierenden Zeitwerte, so würde dies den Signalverlauf verzerren. Für die weitere Verarbeitung sollen jedoch ausschließlich die Spannungswerte ohne Zeitinformation betrachtet werden. Um dies zu ermöglichen, ist eine Interpolation des Signals notwendig. In Fig. 4 ist dieser Arbeitsschritt dargestellt. Mit dem oben definierten Triggerpunkt 401 wird das Ende des Interpolationsbereiches 403 bestimmt. Der Startpunkt errechnet sich aus der Differenz zwischen Endpunkt und einer vorab festgelegten Zeitspanne. Eine lineare Interpolation innerhalb dieses Bereiches bewirkt eine Vereinheitlichung der Schrittweiten. Somit können die einzelnen Signale unabhängig vom zeitlichen Bezug miteinander verglichen werden, ohne dabei den Verlauf der Signale zu verzerren.

Wie in Fig. 4 darüber hinaus ersichtlich ist, eignet sich dieses Vorgehen auch zum Filtern von Default-Werten, welche zu Beginn der Aufzeichnung auftreten können. Eine Zeitreihe besitzt immer dann Default-Werte wenn die Aufzeichnung der Daten aktiv ist, aber noch keine Messung stattfindet. Tritt ein solcher Default-Wert innerhalb des eigentlichen Signalverlaufs auf, so darf dieser nicht entfernt werden, da somit die Messergebnisse manipuliert würden und Informationen über mögliche Defekte der Messeinheit verloren gingen.

**Zeitreihen glätten**

Um das Verhältnis zwischen Nutzsignal und Signalrauschen zu verbessern wird ein Tiefpass erster Ordnung verwendet. Jedoch ist die Abtastrate deutlich zu gering um ein klares Unterdrücken des Rauschens ohne dabei das Nutzsignal zu beeinträchtigen, zu erlauben. Um dennoch eine Grenzfrequenz festlegen zu können, wird ein Kompromiss zwischen verbleibendem Nutzsignal und Rauschen getroffen und die Grenzfrequenz von 0,1 Hz empirisch bestimmt.

**Ausreißer filtern**

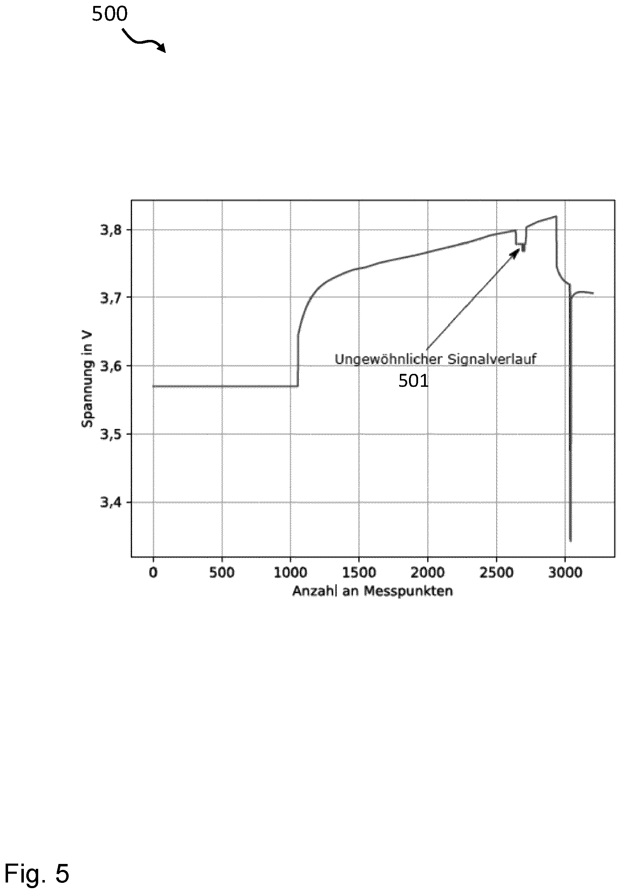

Für die weitere Verarbeitung der Daten muss eine Formähnlichkeit der Messungen gegeben sein, da auf bestimmte Merkmale getriggert wird. Alle definierten Anomalien und auch der Normalfall weisen diese Formähnlichkeit auf. Spannungsverläufe, die eine andere Charakteristik besitzen, müssen somit vorab herausgefiltert werden. In Fig. 5 ist ein mögliches Beispiel für ein Signal mit einem anderen, untypischen Verlauf 501 dargestellt.

Zur Detektion solcher Ausreißer kann beispielsweise Dynamic Time Warping (DTW) Verwendung finden. Diese Methode eignet sich für den Vergleich des Signalverlaufs, da zeitliche Verschiebungen oder Verzerrungen kompensiert werden. Tests ergaben jedoch, dass der Einsatz von DTW mit einem erheblichen Rechen- und Zeitaufwand verbunden ist. Bei Anwendungen mit begrenzter Rechenleistung wäre dies somit keine günstige Option. Damit dennoch das Erkennen solch ungewöhnlicher Verläufe möglich ist, wird das Signal mittels einer diskreten Wavelet-Transformation (DWT) transformiert. Dies bewirkt eine Halbierung der Länge des Signals ohne dabei wesentliche Informationen zu verlieren. Anschließend werden die Detail-Koeffizienten betrachtet, da diese die hochfrequenten Anteile des ursprünglichen Signals beinhalten. Es stellt sich heraus, dass sich alle erzeugten Fälle bei dieser Betrachtung lediglich in der Höhe vier markanter Peaks unterscheiden. Besitzt ein Signal außer den vier Peaks noch weitere, so sind diese auf Abweichungen der Signalform zurückzuführen. Mithilfe der Euklidischen Distanz können die transformierten Signale mit einem Referenzsignal verglichen werden. Da jedoch nur die Bereiche außerhalb der Peaks für diesen Vergleich relevant sind, wird zusätzlich eine Kostenfunktion $f_{cost}$ definiert. Es ergibt sich für die Berechnung der Formähnlichkeit folgender Ausdruck:

$$d_{shape} = \sqrt{\sum_{j=1}^{n} (p_j - q_j)^2 \cdot f_{cost,j}}$$

$p_j$ stellt dabei den $j$-ten Detail-Koeffizienten des zu untersuchenden Signals und $q_j$ den $j$-ten Detail-Koeffizienten des Referenzsignals dar. Die quadrierte Differenz dieser beiden Werte wird anschließend mit $f_{cost}(i)$ multipliziert. Dieser Faktor entspricht dem j-ten Wert der Kostenfunktion. Besitzt die Kostenfunktion an den Stellen der Peaks Nullwerte, so werden diese für die Bestimmung der Formähnlichkeit nicht berücksichtigt. Da bei Realdaten die Peaks entlang der x-Achse verschoben sein können, ist ein rechteckiger Verlauf der Kostenfunktion nicht zielführend. Abhilfe verschafft eine mit dem Abstand zu den Peaks steigende Funktion. Dadurch werden Abweichungen, die weiter von den Peaks entfernt liegen, stärker gewichtet und Abweichungen in der Nähe toleriert. Je höher der Wert von $d_{shape}$ ist, desto unterschiedlicher sind sich die Signale bezüglich ihrer Form.

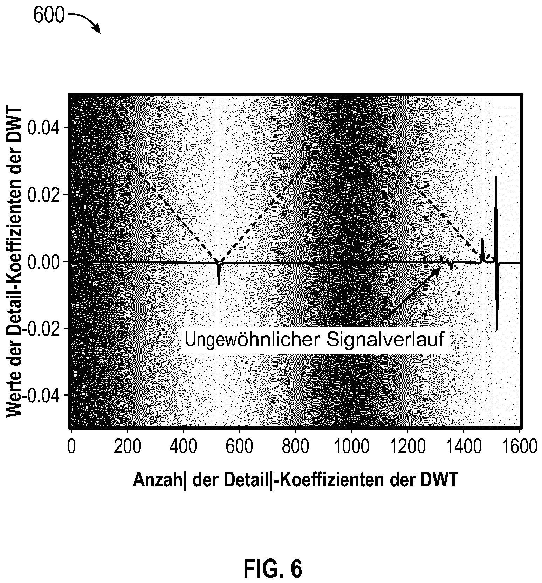

Fig. 6 zeigt das DWT-transformierte Signal aus dem obigen Beispiel und den qualitativen Verlauf einer abschnittsweise linearen Kostenfunktion. Zur Bestimmung der Kostenfunktion wird zunächst das Referenzsignal abgeleitet, um die Positionen der Peaks zu ermitteln. Alle Werte des abgeleiteten Signals, die kleiner als eine vorab festgelegte Grenze sind, werden auf Null gesetzt. Diese Grenze ist das Maximum der Ableitung des Signals im Bereich außerhalb Peaks. Somit bleiben lediglich die Ableitungen der Peaks übrig.

Die einzelnen Werte der Kostenfunktion errechnen sich wie folgt:

$$f_{cost,j} = \begin{cases} w \cdot d_{peak,j}^{k} & falls \ q_j' = 0 \\ 0 & falls \ q_j' \neq 0 \end{cases}$$

Die Parameter w und k werden vom Programmierer festgelegt werden. Mithilfe des Gewichtungsfaktors $w$ ist es möglich, den Toleranzbereich zu variieren. Der Exponent $p$ legt fest, wie schnell die Kostenfunktion in Abhängigkeit vom Abstand $d_{peak}$ ansteigt. Dabei stellt $d_{peak}$ die Distanz zum nächstgelegenen Peak dar. Der $j$-te Wert der Ableitung des transformierten Signals $p$ wird durch $p_j'$ repräsentiert.

## Merkmale extrahieren

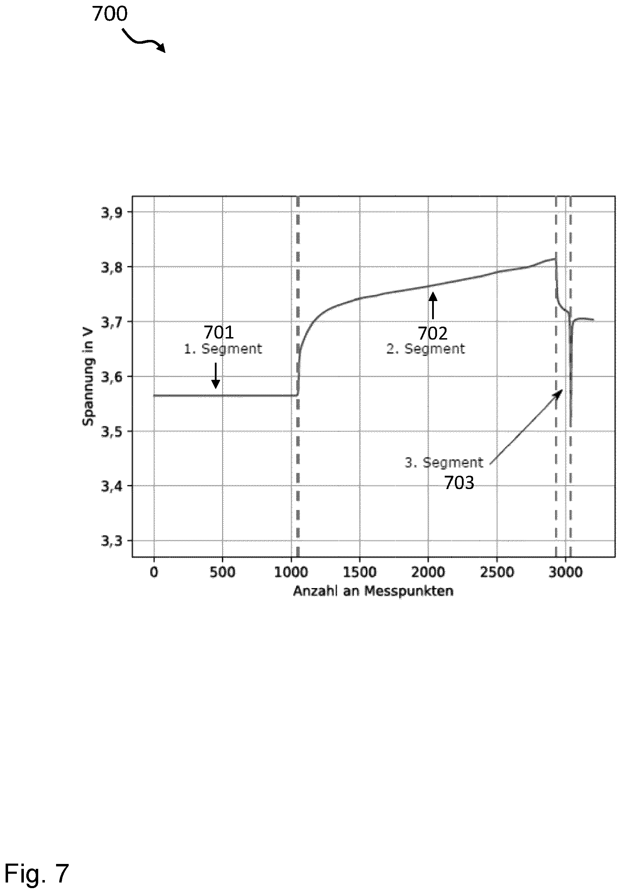

Die zu untersuchenden Anomalien lassen sich mit nur drei physikalischen Größen beschreiben - Offset-Spannung, Zellkapazität und Zellinnenwiderstand. Eine Signalzerlegung in drei Segmente bildet den ersten Schritt der Merkmalsextraktion (siehe Fig. 7). Dabei werden drei Flanken zum Trennen der einzelnen Bereiche verwendet. Durch das Ableiten des Signals ist es möglich, diese Flanken einfach zu ermitteln, da jedes Signal einen ähnlichen Verlauf aufweist und das Messrauschen weitgehend kompensiert ist.

Es wird angenommen, dass sich das erste Segment 701 besonders zur Bestimmung der Offset- Spannung eignet, dass das zweite Segment 702 zur Erkennung niedriger Zellkapazitäten dient und dass der Effekt eines erhöhten Innenwiderstandes verstärkt im dritten Segment 703 zum Vorschein kommt. Aus diesen Effekten wird ebenfalls ersichtlich, dass ein steilerer Signalverlauf im zweiten Segment 702 nicht nur auf eine niedrigere Zellkapazität zurückzuführen ist. Die nichtlineare Beziehung zwischen der Zellspannung und dem State of Charge (SoC) ist auch beim Ladevorgang deutlich zu erkennen und resultiert in einem abweichenden dynamischen Verhalten des Spannungsverlaufs während des Ladens. Da vor dem Endof-Line-Test (EoL-Test) die Batteriesysteme nicht auf einen einheitlichen Ladezustand gebracht werden, kann die Offset-Spannung bei jeder Batterie etwas unterschiedlich sein. Durch eine Messung der Batteriespannung zu Beginn des Tests werden alle Batterien, die nicht innerhalb der definierten Toleranzgrenzen liegen, entfernt. Aus diesem Grund kann angenommen werden, dass die Mehrheit der Zellen einer Batterie, deren Spannung innerhalb des Toleranzbandes liegt, keine Anomalien aufweist. Der unterschiedliche Ladezustand der Batterien erlaubt keine Verwendung eines starren Referenzsignals zum Unterscheiden zwischen Anomalie oder Normalfall. Somit sind auftretende Anomalien als kontextbezogene Anomalien zu deklarieren, da der Signalverlauf alleine keine Aussage über den Zustand der Zelle zulässt. Nachfolgend werden die Batteriesysteme auf Modulebene betrachtet.

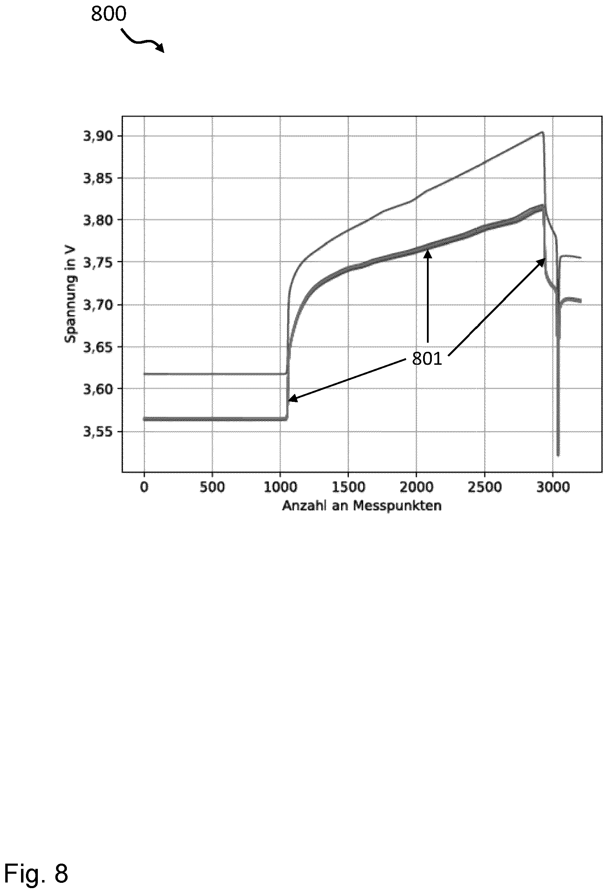

Fig. 8 zeigt die simulierten Spannungsverläufe eines Batteriemoduls mit einer fehlerbehafteten Batteriezelle in einer Ausführungsform und das errechnete Referenzsignal 801. Der Spannungsverlauf des Referenzsignals 801 wird durch die Berechnung des Medians aller Zellspannungen eines Moduls gebildet. Der Median eignet sich besser als Referenz als der arithmetische Mittelwert, da Ausreißer auf den Median einen wesentlich geringeren Einfluss haben. Werden mehrere Spannungsverläufe betrachtet, so kann man diese wie folgt darstellen:

$$\mathbf{X} = \begin{pmatrix} x_{1,1} & x_{1,2} & \cdots & x_{1,j} & \cdots & x_{1,n} \\ x_{2,1} & x_{2,2} & \cdots & x_{2,j} & \cdots & x_{2,n} \\ \vdots & \vdots & \ddots & \vdots & \ddots & \vdots \\ x_{i,1} & x_{i,2} & \cdots & x_{i,j} & \cdots & x_{i,n} \\ \vdots & \vdots & \ddots & \vdots & \ddots & \vdots \\ x_{m,1} & x_{m,2} & \cdots & x_{m,j} & \cdots & x_{m,n} \end{pmatrix} \quad mit \quad i \in \mathbb{N}, \ 1 \leq i \leq m \ \text{und} \ j \in \mathbb{N}, \ 1 \leq j \leq n$$

Die Anzahl der Spannungsverläufe wird durch *m* und die Anzahl der Messpunkte durch *n* wiedergegeben. Somit gilt für das Referenzsignal:

$$\vec{x}_{ref} = \left(\tilde{x}_1, \tilde{x}_2, \cdots, \tilde{x}_j, \cdots, \tilde{x}_n\right) \quad \text{mit} \quad \tilde{x}_j = \begin{cases} x_{\frac{n+1}{2},j} & \text{falls } n \text{ ungerade} \\[2ex] \frac{1}{2}\left(x_{\frac{n}{2},j} + x_{\frac{n}{2}+1,j}\right) & \text{falls } n \text{ gerade} \end{cases}$$

Das erzeugte Referenzsignal dient zum Detektieren derjenigen Zelle, die sich bezüglich des Spannungsverlaufs am meisten von den anderen Zellen eines Moduls unterscheidet. Dabei wird für jedes Modul das Referenzsignal neu gebildet. Da es vorkommen kann, dass mehrere Zellen eines Moduls unterschiedliche Anomalien aufweisen, wird für jedes Segment der Vergleich zwischen Zellspannung und Referenzspannung getroffen. Nachfolgend werden die Schritte zur Merkmalsextraktion in den jeweiligen Segmenten erklärt.

**Offset-Spannung**

Da eine zu hohe oder eine zu niedrige Offset-Spannung einen Fehler darstellen, ist nur der betragsmäßige Unterschied zwischen Zelle und Referenz von Bedeutung. Die Zelle mit der größten Differenz zum Referenzsignal ist demnach diejenige, die am meisten vom Ideal abweicht.

**Zellkapazität**

Im zweiten Segment wird versucht, Informationen über die Zellkapazität zu extrahieren. Damit ein Vergleich des Ladeverhaltens möglich ist, werden zunächst alle Spannungen auf einen einheitlichen Startwert gesetzt. Als Startwert wird 0 V gewählt, da dies durch Subtraktion des ersten Spannungswertes innerhalb des zweiten Segments einfach realisierbar ist. Anschließend wird auch hier die fehlerbehaftetste Zelle detektiert. Diese ist durch den steilsten Spannungsverlauf erkennbar.

**Innenwiderstand**

Auch im dritten Segment wird die Offset-Spannung kompensiert, da nur der relative Spannungssprung Rückschlüsse auf den Innenwiderstand einer Zelle zulässt. Derzeit werden zu hohe Spannungssprünge, welche ein Indiz für hohe Innenwiderstände sind, genauso als Anomalie betrachtet, wie zu niedrige Spannungssprünge, da hier ebenfalls eine betragsmäßige Betrachtung der Spannungsdifferenzen vorgenommen wird.

Zur Selektion derjenigen Zelle, die bezüglich ihres Spannungsverlaufs am meisten von der Referenzzelle abweicht, wird deren Segmentsignal $\vec{x}_{sec}$ extrahiert, wobei gilt:

$$\vec{x}_{sec} \in \left\{ \vec{x}_i \,\middle|\, \sum_{j=1}^{n} d_{sec,i,j} = \max_{1 \leq i \leq m}\left(\sum_{j=1}^{n} d_{sec,i,j}\right) \right\}$$

$d_{sec,i,j}$ berechnet sich folgendermaßen:

$$d_{sec,i,j} = \begin{cases} |x_{i,j} - \tilde{x}_j| & \text{für Segment 1 oder 3} \\[2ex] x'_{i,j} & \text{für Segment 2} \end{cases}$$

Für jedes Modul und Segment erhält man somit eine Zeitreihe. Nun wird versucht, die Daten zu reduzieren. Dies geschieht mithilfe einer Hauptkomponentenanalyse. Dieses Verfahren eignet sich hier, da für jedes Segment diejenigen Punkte identifiziert werden, die den größten Informationsgehalt aufweisen. Redundante Informationen entfallen dadurch. Es stellt sich heraus, dass nach der Hauptkomponentenanalyse ein einziger Punkt pro Segment genügt, um die wesentliche Charakteristik beizubehalten. Dadurch erhält man einen Feature-Vektor mit drei Einträgen.

$$\vec{v}_{feat,k} := \left( c_{k,1},\ c_{k,2},\ c_{k,3} \right)$$

Eintrag $c_{k,l}$ mit $l \in \mathbb{N}$ und $1 \le l \le 3$ des Vektors $\vec{v}_{feat,k}$ stellt die durch Hauptkomponentenanalyse (engl. : Principal Component Analysis (PCA)) transformierte Hauptkomponente des $l$-ten Segments und des $k$-ten Moduls dar.

Da der Wertebereich der einzelnen Segmente stark unterschiedlich sein kann, wird anschließend noch eine Standardisierung vorgenommen und somit ein Mittelwert von Null und eine empirische Varianz von Eins erzielt. Dieser Schritt ermöglicht es, die Leistung vieler Machine-Learning Algorithmen deutlich zu steigern. Betrachtet man nun den gesamten Trainingsdatensatz, so erhält man folgende Matrix V, welche aus mehreren Feature-Vektoren besteht.

$$\mathbf{V} = \begin{pmatrix} \vec{v}_{feat,1} \\ \vec{v}_{feat,2} \\ \vdots \\ \vec{v}_{feat,N} \end{pmatrix} = \begin{pmatrix} c_{1,1} & c_{1,2} & c_{1,3} \\ c_{2,1} & c_{2,2} & c_{2,3} \\ \vdots & \vdots & \vdots \\ c_{N,1} & c_{N,2} & c_{N,3} \end{pmatrix}$$

Die Standardisierung erfolgt anschließend durch folgende Transformation:

$$\vec{z}_l = \frac{\vec{c}_l - \bar{c}_l \cdot (1, 1, \cdots, 1)^T}{\sigma_{c_l}}$$

Für die Standardabweichung $\sigma_{cl}$ gilt:

$$\sigma_{c_l} = \sqrt{\frac{1}{N} \sum_k \left( c_{k,l} - \bar{c}_l \right)^2}$$

Durch das Standardisieren der Merkmale können Unterschiede klarer hervorgehoben und unterschiedliche Größenordnungen der einzelnen Merkmale kompensiert werden.

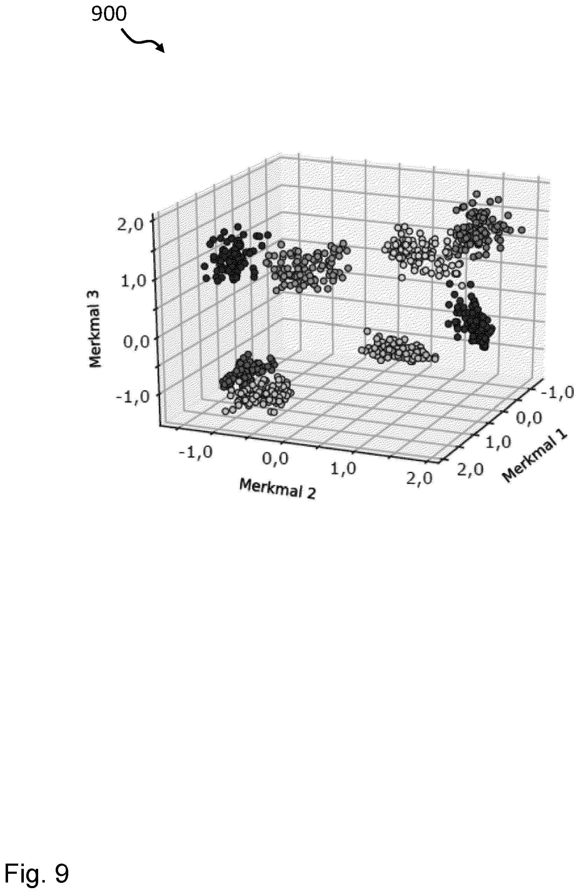

Die Feature-Vektoren können anschließend als Punkte im dreidimensionalen Raum dargestellt werden. Die Datenpunkte sind ihren Gruppen entsprechend eingefärbt. In der Fig. 9 sind die einzelnen Feature-Vektoren zu den Fällen aus Tabelle 200 in Fig. 2 dargestellt. In Fig. 9 ist das Ergebnis der Merkmalsextraktion anhand eines Beispieldatensatzes zu sehen. Zu erkennen ist hierbei, dass die verschiedenen Gruppen eindeutig voneinander abgetrennt sind. Dies lässt den Rückschluss zu, dass die Merkmalsextraktion erfolgreich verlaufen ist.

Zum Kategorisieren der Anomalien können mehrere Klassifizierungsalgorithmen, wie z.B. Logistische Regression, Support Vector Machine, Random Forest, Mehrschichtiges Perzeptron, getestet werden.

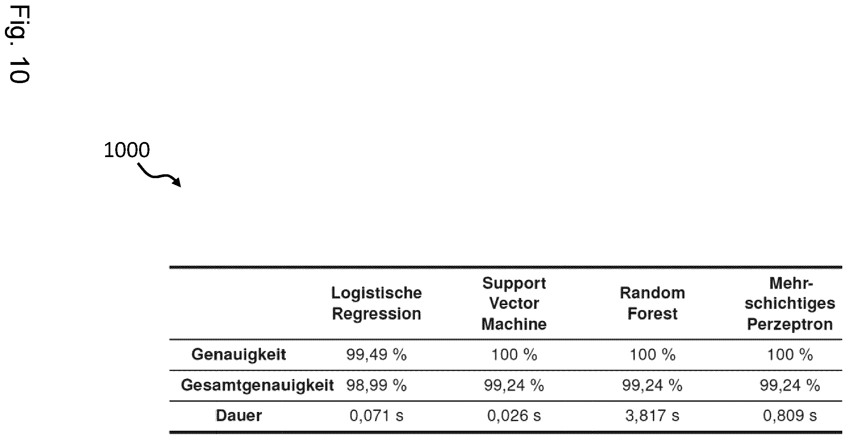

Fig. 10 zeigt eine Tabelle 1000 der Ergebnisse der verschiedenen Klassifizierungsalgorithmen beim Training mit k-Means in einer Ausführungsform. Wie aus der Fig. 10 ersichtlich ist, liefert die Support Vector Machine das beste Ergebnis, wobei die Support Vector Machine eine korrekte Klassifizierung der Daten in nur 3 % der vom mehrschichtigen Perzeptron benötigten Zeit durchführt.

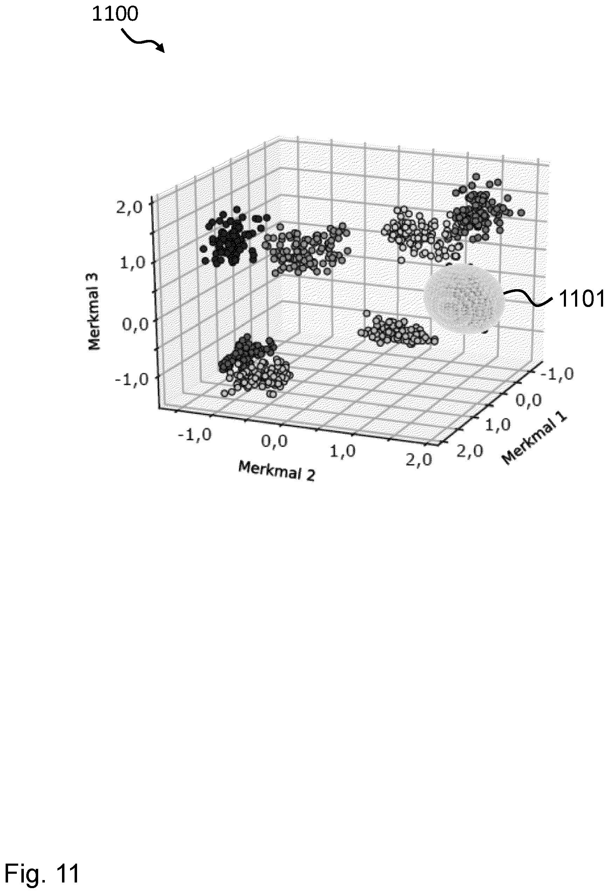

In einer Ausführungsform wird nach dem Klassifizierer eine One-Class Support Vector Machine eingesetzt, um eine restriktivere Betrachtung von Anomalie und Normalfall zu ermöglichen. Diese soll anhand von Normalfällen, welche in den Trainingsdaten enthalten sind, strikte Grenzen für Normalfälle im Merkmalsraum festlegen. In Fig. 11 ist die von der One-Class Support Vector Machine erzeugte Grenzfläche 1101 zu sehen. Alle Datenpunkte, die außerhalb dieser Grenze liegen, werden unbeachtet vom Resultat des Klassifizierers als Anomalie deklariert. Damit eine Zuordnung zu einem Anomalietyp möglich ist, wird das Label mit der zweithöchsten Wahrscheinlichkeit vergeben.

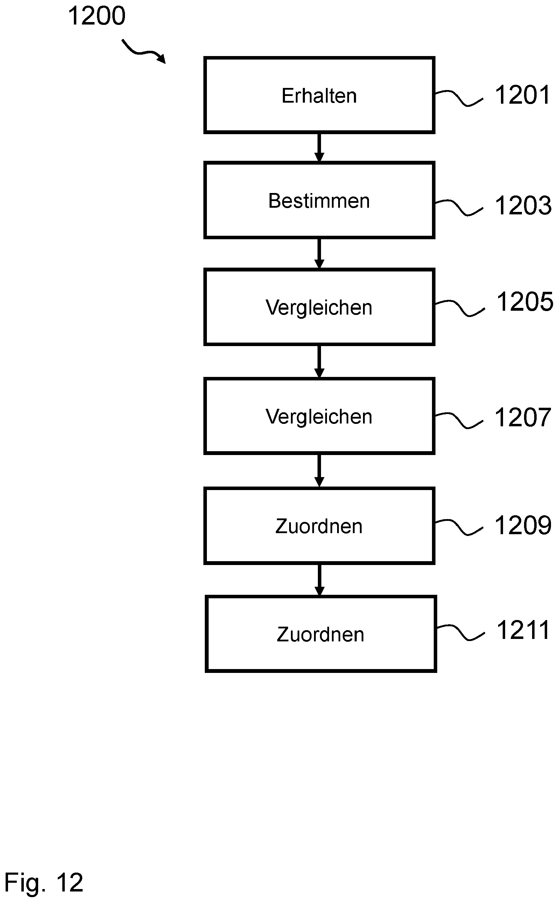

Fig. 12 zeigt ein Flussdiagramm für ein Verfahren 1200 gemäß einem Ausführungsbeispiel.

Das Verfahren 1200 zum Batteriemanagement umfasst als ersten Verfahrensschritt das Erhalten 1201 eines ersten Spannungsverlaufs über einer ersten Batteriezelle eines Batteriemoduls und eines zweiten Spannungsverlaufs über einer zweiten Batteriezelle des Batteriemoduls, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist.

Das Verfahren 1200 umfasst als zweiten Verfahrensschritt das Bestimmen 1203 eines Referenzspannungsverlaufs auf der Basis eines Spannungsmittelwertes aus dem ersten Spannungsverlauf und aus dem zweiten Spannungsverlauf, wobei der Referenzspannungsverlauf einen ersten Referenzspannungsverlaufsabschnitt und einen zweiten Referenzspannungsverlaufsabschnitt aufweist.

Das Verfahren 1200 umfasst als dritten Verfahrensschritt das Vergleichen 1205 des ersten Spannungsverlaufs mit dem Referenzspannungsverlauf, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt.

Das Verfahren 1200 umfasst als vierten Verfahrensschritt das Vergleichen 1207 des zweiten Spannungsverlaufs mit dem Referenzspannungsverlauf, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt;

Das Verfahren 1200 umfasst als fünften Verfahrensschritt das Zuordnen 1209 einer ersten elektrischen Charakteristik dem ersten Spannungsverlaufsabschnitt und einer zweiten elektrischen Charakteristik dem zweiten Spannungsverlaufsabschnitt, falls die erste Metrik größer als die zweite Metrik ist, um das Batteriemodul durch die erste elektrische Charakteristik und die zweite elektrische Charakteristik zu klassifizieren, oder als sechsten Verfahrensschritt das Zuordnen 1211 einer dritten elektrischen Charakteristik dem dritten Spannungsverlaufsabschnitt und einer vierten elektrischen Charakteristik dem zweiten Spannungsverlaufsabschnitt, falls die erste Metrik kleiner als die zweite Metrik ist, um das Batteriemodul durch die dritte elektrische Charakteristik und die vierte elektrische Charakteristik zu klassifizieren.

## Bezugszeichenliste

| | |
|---|---|
| 100 | Batteriemanagementsystem |
| 101 | Schnittstelle |
| 103 | Prozessor |
| 105 | Speicher |
| 200 | Tabelle der definierten Anomalietypen |
| 300 | Parametereinstellungen |
| 301a | Normalfälle |
| 301b | Normalfälle |
| 301c | Normalfälle |
| 301d | Normalfälle |
| 303 | Anomaliefälle |
| 305 | Anomaliefälle |
| 307 | Anomaliefälle |
| 400 | Spannungsverlauf |
| 401 | Triggerpunkt |
| 403 | Interpolationsbereich |
| 500 | Spannungsverlauf |
| 501 | Untypischer Signalverlauf |
| 600 | Diskreten-Wavelet-Transformation (DWT) transformiertes Signal |
| 700 | Spannungsverlauf |
| 701 | Erstes Segment |
| 702 | Zweites Segment |
| 703 | Drittes Segment |
| 800 | Simulierte Spannungsverläufe |
| 801 | Referenzsignal |
| 900 | Feature-Vektoren |
| 1000 | Tabelle der Ergebnisse der verschiedenen Klassifizierungsalgorithmen |
| 1100 | Feature-Vektoren |
| 1101 | Grenzfläche für Normalfälle |
| 1200 | Verfahren zum Batteriemanagement |

1201   Erster Verfahrensschritt: Erhalten eines ersten Spannungsverlaufs und eines zweiten Spannungsverlaufs
1203   Zweiter Verfahrensschritt: Bestimmen eines Referenzspannungsverlaufs
1205   Dritter Verfahrensschritt: Vergleichen des ersten Spannungsverlaufs mit dem Referenzspannungsverlauf
1207   Vierter Verfahrensschritt: Vergleichen des zweiten Spannungsverlaufs mit dem Referenzspannungsverlauf
1209   Fünfter Verfahrensschritt: Zuordnen einer ersten elektrischen Charakteristik dem ersten Spannungsverlaufsabschnitt und einer zweiten elektrischen Charakteristik dem zweiten Spannungsverlaufsabschnitt
1211   Sechster Verfahrensschritt: Zuordnen einer dritten elektrischen Charakteristik dem dritten Spannungsverlaufsabschnitt und einer vierten elektrischen Charakteristik dem vierten Spannungsverlaufsabschnitt

**Patentansprüche**

1. Batteriemanagementsystem (100) zum Klassifizieren eines Batteriemoduls, wobei das Batteriemodul eine erste Batteriezelle und eine zweite Batteriezelle aufweist, mit:

   einer Schnittstelle (101) zum Erhalten eines ersten Spannungsverlaufs über der ersten Batteriezelle und eines zweiten Spannungsverlaufs über der zweiten Batteriezelle, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist;
   einem Prozessor (103),
   **dadurch gekennzeichnet, dass** der Prozessor (103) ausgebildet ist:

      einen Referenzspannungsverlauf auf der Basis eines Spannungsmittelwertes aus dem ersten Spannungsverlauf und aus dem zweiten Spannungsverlauf zu bestimmen, wobei der Referenzspannungsverlauf einen ersten Referenzspannungsverlaufsabschnitt und einen zweiten Referenzspannungsverlaufsabschnitt aufweist;
      den ersten Spannungsverlauf mit dem Referenzspannungsverlauf zu vergleichen, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt;
      den zweiten Spannungsverlauf mit dem Referenzspannungsverlauf zu vergleichen, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt;
      dem ersten Spannungsverlaufsabschnitt eine erste elektrische Charakteristik zuzuordnen und dem zweiten Spannungsverlaufsabschnitt eine zweite elektrische Charakteristik zuzuordnen, falls die erste Metrik größer als die zweite Metrik ist, um das Batteriemodul durch die erste elektrische Charakteristik und die zweite elektrische Charakteristik zu klassifizieren;
      oder
      dem dritten Spannungsverlaufsabschnitt eine dritte elektrische Charakteristik zuzuordnen und dem vierten Spannungsverlaufsabschnitt eine vierte elektrische Charakteristik zuzuordnen, falls die erste Metrik kleiner als die zweite Metrik ist, um das Batteriemodul durch die dritte elektrische Charakteristik und die vierte elektrische Charakteristik zu klassifizieren.

2. Batteriemanagementsystem (100) nach Anspruch 1, mit einem Speicher (105), welcher ausgebildet ist, eine Mehrzahl von elektrischen Charakteristika zu speichern, wobei der Prozessor (103) ausgebildet ist, die jeweilige elektrische Charakteristik aus dem Speicher (105) auszulesen.

3. Batteriemanagementsystem (100) nach einem der vorhergehenden Ansprüche, wobei der Prozessor (103) ausgebildet ist, den Referenzspannungsverlauf auf der Basis des ersten Spannungsverlaufs und des zweiten Spannungsverlaufs zu bestimmen.

4. Batteriemanagementsystem (100) nach Anspruch 3, wobei der Referenzspannungsverlauf einen Median oder einen Durchschnitt aus dem ersten Spannungsverlauf und aus dem zweiten Spannungsverlauf umfasst.

5. Batteriemanagementsystem (100) nach einem der vorhergehenden Ansprüche, wobei das Batteriemodul eine dritte Batteriezelle aufweist und die Schnittstelle ausgebildet ist, einen dritten Spannungsverlauf über der dritten Batteriezelle zu erhalten, wobei der Prozessor (103) ausgebildet ist, den Referenzspannungsverlauf auf der Basis des ersten Spannungsverlaufs, des zweiten Spannungsverlaufs und des dritten Spannungsverlaufs zu bestimmen.

6. Batteriemanagementsystem (100) nach Anspruch 5, wobei der Referenzspannungsverlauf einen Median, einen Durchschnitt oder einen Modus aus dem ersten Spannungsverlauf, dem zweiten Spannungsverlauf und dem dritten Spannungsverlauf umfasst.

7. Batteriemanagementsystem (100) nach einem der vorhergehenden Ansprüche, wobei der Prozessor (103) ausgebildet ist:

   die erste elektrische Charakteristik auf der Basis des ersten Spannungsverlaufsabschnitts des ersten Spannungsverlaufs und die zweite elektrische Charakteristik auf der Basis des zweiten Spannungsverlaufsabschnitts des ersten Spannungsverlaufs mittels einer Hauptkomponentenanalyse zu bestimmen, wobei die erste elektrische Charakteristik den ersten Spannungsverlaufsabschnitt des ersten Spannungsverlaufs repräsentiert und die zweite elektrische Charakteristik den zweiten Spannungsverlaufsabschnitt des ersten Spannungsverlaufs repräsentiert, und/oder
   die dritte elektrische Charakteristik auf der Basis des dritten Spannungsverlaufsabschnitts des zweiten Spannungsverlaufs und die vierte elektrische Charakteristik auf der Basis des vierten Spannungsverlaufsabschnitts des zweiten Spannungsverlaufs mittels der Hauptkomponentenanalyse zu bestimmen, wobei die dritte elektrische Charakteristik den dritten Spannungsverlaufsabschnitt des zweiten Spannungsverlaufs repräsentiert und die vierte elektrische Charakteristik den vierten Spannungsverlaufsabschnitt des zweiten Spannungsverlaufs repräsentiert.

8. Batteriemanagementsystem (100) nach einem der vorhergehenden Ansprüche, wobei der Prozessor (103) ausgebildet ist, ein erstes elektrisches Merkmal auf der Basis des ersten Spannungsverlaufsabschnitts des ersten Spannungsverlaufs, ein zweites elektrisches Merkmal auf der Basis des zweiten Spannungsverlaufsabschnitts des ersten Spannungsverlaufs, ein drittes elektrisches Merkmal auf der Basis des dritten Spannungsverlaufsabschnitts des zweiten Spannungsverlaufs, ein viertes elektrisches Merkmal auf der Basis des vierten Spannungsverlaufsabschnitts des zweiten Spannungsverlaufs zu bestimmen.

9. Batteriemanagementsystem (100) nach Anspruch 8, wobei das erste elektrische Merkmal einer Offset-Spannung der ersten Batteriezelle entspricht und das dritte elektrische Merkmal einer weiteren Offset-Spannung der zweiten Batteriezelle entspricht, wobei das zweite elektrische Merkmal einem Innenwiderstand der ersten Batteriezelle entspricht und das vierte elektrische Merkmal einem weiteren Innenwiderstand der zweiten Batteriezelle entspricht.

10. Batteriemanagementsystem (100) nach einem der vorhergehenden Ansprüche, wobei der Prozessor (103) ausgebildet ist, das Batteriemodul mittels eines Klassifizierungsalgorithmus zu klassifizieren, wobei der Klassifizierungsalgorithmus mindestens einen von logistischer Regression, Support Vector Machine, Random Forest, mehrschichtigem Perzeptron und One-Class Support Vector Machine umfasst.

11. Batteriemanagementsystem (100) nach einem der vorhergehenden Ansprüche, wobei die Schnittstelle (101) ausgebildet ist, eine erste Mehrzahl von Spannungsverläufen und eine zweite Mehrzahl von Spannungsverläufen zu erhalten, wobei jeder der ersten Mehrzahl von Spannungsverläufen einer ersten Batteriezelle eines einer Mehrzahl von Batteriemodulen entspricht und jeder der zweiten Mehrzahl von Spannungsverläufen einer zweiten Batteriezelle eines der Mehrzahl von Batteriemodulen entspricht, wobei die Schnittstelle ausgebildet ist, die Mehrzahl von Batteriemodulen als fehlerfrei zu handhaben,
wobei der Prozessor (103) ausgebildet ist, jedes Batteriemodul der Mehrzahl von Batteriemodulen zu klassifizieren, um auf der Basis der Klassifizierung eine Referenzgruppe zu bilden.

12. Batteriemanagementsystem (100) nach Anspruch 11, wobei der Prozessor (103) ausgebildet ist, die Mehrzahl von Batteriemodulen mittels eines weiteren Klassifizierungsalgorithmus zu klassifizieren, wobei der weitere Klassifizierungsalgorithmus mindestens einen von logistischer Regression, Support Vector Machine, Random Forest, mehrschichtigem Perzeptron und One-Class Support Vector Machine umfasst.

13. Batteriemanagementsystem (100) nach einem der vorhergehenden Ansprüche, wobei der erste Spannungsverlauf einen fünften Spannungsverlaufsabschnitt aufweist und der zweite Spannungsverlauf einen sechsten Spannungsverlaufsabschnitt aufweist, wobei der Prozessor (103) ausgebildet ist, ein fünftes Merkmal auf der Basis des fünften Spannungsverlaufsabschnitts des ersten Spannungsverlaufs und ein sechstes Merkmal auf der Basis des sechsten Spannungsverlaufsabschnitts des zweiten Spannungsverlaufs zu extrahieren.

14. Batteriemanagementsystem (100) nach Anspruch 13, wobei das fünfte Merkmal einer Kapazität der ersten Batteriezelle entspricht und das sechste Merkmal einer weiteren Kapazität der zweiten Batteriezelle entspricht.

15. Batteriemanagementsystem (100) nach einem der vorhergehenden Ansprüche, wobei die Schnittstelle (101) ausgebildet ist, eine Anzahl an zu erzeugenden Gruppen, eine weitere erste Mehrzahl von Spannungsverläufen und eine weitere zweite Mehrzahl von Spannungsverläufen zu erhalten, wobei jeder der weiteren ersten Mehrzahl von Spannungsverläufen einer ersten Batteriezelle eines einer weiteren Mehrzahl von Batteriemodulen entspricht und wobei jeder der weiteren zweiten Mehrzahl von Spannungsverläufen einer zweiten Batteriezelle eines der weiteren Mehrzahl von Batteriemodulen entspricht,
wobei der Prozessor (103) ausgebildet ist, jedes Batteriemodul der weiteren Mehrzahl von Batteriemodulen mittels des Klassifizierungsalgorithmus einer Mehrzahl von Gruppen zuzuordnen, wobei die Menge der Mehrzahl von Gruppen gleich mit der Anzahl an zu erzeugenden Gruppen ist.

16. Verfahren (1200) zum Batteriemanagement, wobei das Verfahren (1200) folgenden Schritt umfasst:

Erhalten (1201) eines ersten Spannungsverlaufs über einer ersten Batteriezelle eines Batteriemoduls und eines zweiten Spannungsverlaufs über einer zweiten Batteriezelle des Batteriemoduls, wobei der erste Spannungsverlauf einen ersten Spannungsverlaufsabschnitt und einen zweiten Spannungsverlaufsabschnitt aufweist, und wobei der zweite Spannungsverlauf einen dritten Spannungsverlaufsabschnitt und einen vierten Spannungsverlaufsabschnitt aufweist;
**dadurch gekennzeichnet, dass** das Verfahren ferner die Schritte umfasst:

Bestimmen (1203) eines Referenzspannungsverlaufs auf der Basis eines Spannungsmittelwertes aus dem ersten Spannungsverlauf und aus dem zweiten Spannungsverlauf, wobei der Referenzspannungsverlauf einen ersten Referenzspannungsverlaufsabschnitt und einen zweiten Referenzspannungsverlaufsabschnitt aufweist;
Vergleichen (1205) des ersten Spannungsverlaufs mit dem Referenzspannungsverlauf, um eine erste Metrik zu erhalten, welche eine erste Spannungsabweichung zwischen dem ersten Spannungsverlaufsabschnitt und dem ersten Referenzspannungsverlaufsabschnitt und eine zweite Spannungsabweichung zwischen dem zweiten Spannungsverlaufsabschnitt und dem zweiten Referenzspannungsverlaufsabschnitt angibt;
Vergleichen (1207) des zweiten Spannungsverlaufs mit dem Referenzspannungsverlauf, um eine zweite Metrik zu erhalten, welche eine dritte Spannungsabweichung zwischen dem dritten Spannungsverlaufsabschnitt und dem ersten Referenzspannungsverlaufsabschnitt und eine vierten Spannungsabweichung zwischen dem vierten Spannungsverlaufsabschnitt und dem zweiten Referenzspannungsverlaufsabschnitt angibt;
Zuordnen (1209) einer ersten elektrischen Charakteristik dem ersten Spannungsverlaufsabschnitt und einer zweiten elektrischen Charakteristik dem zweiten Spannungsverlaufsabschnitt, falls die erste Metrik größer als die zweite Metrik ist, um das Batteriemodul durch die erste elektrische Charakteristik und die zweite elektrische Charakteristik zu klassifizieren;
oder
Zuordnen (1211) einer dritten elektrischen Charakteristik dem dritten Spannungsverlaufsabschnitt und einer vierten elektrischen Charakteristik dem vierten Spannungsverlaufsabschnitt, falls die erste Metrik kleiner als die zweite Metrik ist, um das Batteriemodul durch die dritte elektrische Charakteristik und die vierte elektrische Charakteristik zu klassifizieren.

## Claims

1. A battery management system (100) for classifying a battery module, the battery module comprising a first battery cell and a second battery cell, comprising:

an interface (101) for obtaining a first voltage curve across the first battery cell and a second voltage curve across the second battery cell, wherein the first voltage curve comprises a first voltage curve segment and a second voltage curve segment, and wherein the second voltage curve comprises a third voltage curve segment and a fourth voltage curve segment;

a processor (103),

**characterized in that** the processor (103) is formed:

to determine a reference voltage curve on the basis of an average voltage value from the first voltage curve and from the second voltage curve, the reference voltage curve having a first reference voltage curve section and a second reference voltage curve section;

comparing the first voltage curve with the reference voltage curve to obtain a first metric indicating a first voltage deviation between the first voltage curve portion and the first reference voltage curve segment and a second voltage deviation between the second voltage curve segment and the second reference voltage curve segment;

comparing the second voltage curve with the reference voltage curve to obtain a second metric indicating a third voltage deviation between the third voltage curve segment and the first reference voltage curve segment and a fourth voltage deviation between the fourth voltage curve segment and the second reference voltage curve segment;

assigning a first electrical characteristic to the first voltage curve segment and assigning a second electrical characteristic to the second voltage curve segment if the first metric is higher than the second metric to classify the battery module by the first electrical characteristic and the second electrical characteristic; or assigning a third electrical characteristic to the third voltage curve segment and assigning a fourth electrical characteristic to the fourth voltage curve segment if the first metric is lower than the second metric to classify the battery module by the third electrical characteristic and the fourth electrical characteristic.

2. Battery management system (100) according to claim 1, having a memory (105) which is designed to store a plurality of electrical characteristics, the processor (103) being designed to read the respective electrical characteristic from the memory (105).

3. Battery management system (100) according to one of the preceding claims, wherein the processor (103) is designed to determine the reference voltage curve on the basis of the first voltage curve and the second voltage curve.

4. Battery management system (100) according to claim 3, wherein the reference voltage curve comprises a median or an average of the first voltage curve and the second voltage curve.

5. Battery management system (100) according to one of the preceding claims, wherein the battery module comprises a third battery cell and the interface is adapted to obtain a third voltage curve across the third battery cell, wherein the processor (103) is adapted to determine the reference voltage curve on the basis of the first voltage curve, the second voltage curve and the third voltage curve.

6. Battery management system (100) according to claim 5, wherein the reference voltage curve comprises a median, an average or a mode of the first voltage curve, the second voltage curve and the third voltage curve.

7. Battery management system (100) according to one of the preceding claims, wherein the processor (103) is formed:

to determine the first electrical characteristic on the basis of the first voltage curve segment of the first voltage curve and the second electrical characteristic on the basis of the second voltage curve segment of the first voltage curve by means of a principal component analysis, wherein the first electrical characteristic represents the first voltage curve segment of the first voltage curve and the second electrical characteristic represents the second curve segment of the first voltage waveform, and/or

to determine the third electrical characteristic on the basis of the third voltage curve segment of the second voltage curve and the fourth electrical characteristic on the basis of the fourth voltage curve segment of the second voltage curve by means of principal component analysis, wherein the third electrical characteristic represents the third voltage curve segment of the second voltage curve and the fourth electrical characteristic represents the fourth voltage curve segment of the second voltage curve.

8. Battery management system (100) according to one of the preceding claims, wherein the processor (103) is designed to determine a first electrical characteristic on the basis of the first voltage curve segment of the first voltage curve, a second electrical characteristic on the basis of the second voltage curve segment of the first voltage curve, a third electrical characteristic on the basis of the third voltage curve segment of the second voltage curve, a fourth electrical characteristic on the basis of the fourth voltage curve segment of the second voltage curve.

9. Battery management system (100) according to claim 8, wherein the first electrical characteristic corresponds to an offset voltage of the first battery cell and the third electrical characteristic corresponds to a further offset voltage of the second battery cell, wherein the second electrical characteristic corresponds to an internal resistance of the first battery cell and the fourth electrical characteristic corresponds to a further internal resistance of the second battery cell.

10. Battery management system (100) according to any one of the preceding claims, wherein the processor (103) is adapted to classify the battery module by means of a classification algorithm, wherein the classification algorithm comprises at least one of logistic regression, Support Vector Machine, Random Forest, multilayer perceptron and One-Class Support Vector Machine.

11. Battery management system (100) according to one of the preceding claims, wherein the interface (101) is adapted to obtain a first plurality of voltage curves and a second plurality of voltage curves, wherein each of the first plurality of voltage curves corresponds to a first battery cell of one of a plurality of battery modules and each of the second plurality of voltage curves corresponding to a second battery cell of one of the plurality of battery modules, wherein the interface is adapted to handle the plurality of battery modules error-free,
wherein the processor (103) is adapted to classify each battery module of the plurality of battery modules to form a reference group based on the classification.

12. Battery management system (100) according to claim 11, wherein the processor (103) is adapted to classify the plurality of battery modules by means of a further classification algorithm, wherein the further classification algorithm comprises at least one of logistic regression, Support Vector Machine, Random Forest, multilayer perceptron and One-Class Support Vector Machine.

13. Battery management system (100) according to any one of the preceding claims, wherein the first voltage curve comprises a fifth voltage curve segment and the second voltage curve comprises a sixth voltage curve segment, wherein the processor (103) is adapted to extract a fifth feature based on the fifth voltage curve segment of the first voltage curve and a sixth feature based on the sixth voltage curve segment of the second voltage curve.

14. Battery management system (100) according to claim 13, wherein the fifth feature corresponds to a capacity of the first battery cell and the sixth feature corresponds to a further capacity of the second battery cell.

15. Battery management system (100) according to one of the preceding claims, wherein the interface (101) is configured to obtain a number of groups to be generated, a further first plurality of voltage curves and a further second plurality of voltage curves, wherein each of the further first plurality of voltage curves corresponds to a first battery cell of one of a further plurality of battery modules and wherein each of the further second plurality of voltage curves corresponds to a second battery cell of one of the further plurality of battery modules,
wherein the processor (103) is adapted to assign each battery module of the further plurality of battery modules to a plurality of groups by means of the classification algorithm, wherein the amount of the plurality of groups is equal to the number of groups to be generated.

16. Method (1200) for the management of batteries, the method (1200) comprising the step of:

Obtaining (1201) a first voltage curve across a first battery cell of a battery module and a second voltage curve across a second battery cell of the battery module, wherein the first voltage curve comprises a first voltage curve segment and a second voltage curve segment, and wherein the second voltage curve comprises a third voltage curve segment and a fourth voltage curve segment;
**characterized in that** the method further comprises the steps:

determining (1203) a reference voltage curve on the basis of an average voltage value from the first voltage curve and from the second voltage curve, wherein the reference voltage curve comprises a first reference voltage curve segment and a second reference voltage curve segment;
comparing (1205) the first voltage curve with the reference voltage curve to obtain a first metric indicative of a first voltage deviation between the first voltage curve segment and the first reference voltage curve segment and a second voltage deviation between the second voltage curve segment and the second reference voltage curve segment;
comparing (1207) the second voltage curve with the reference voltage curve to obtain a second metric indicative of a third voltage deviation between the third voltage curve segment and the first reference voltage curve segment and a fourth voltage deviation between the fourth voltage curve segment and the second reference voltage curve segment;

assigning (1209) a first electrical characteristic to the first voltage curve segment and a second electrical characteristic to the second voltage curve segment, if the first metric is higher than the second metric, to classify the battery module by the first electrical characteristic and the second electrical characteristic; or

assigning (1211) a third electrical characteristic to the third voltage curve segment and a fourth electrical characteristic to the fourth voltage curve segment if the first metric is smaller than the second metric, to classify the battery module by the third electrical characteristic and the fourth electrical characteristic.

**Revendications**

1. Système de gestion de batterie (100) pour classer un module de batterie, le module de batterie comprenant un premier élément de batterie et un deuxième élément de batterie, comprenant :

   une interface (101) pour obtenir une première forme d'onde de tension aux bornes du premier élément de batterie et une deuxième forme d'onde de tension aux bornes du deuxième élément de batterie, dans lequel la première forme d'onde de tension comprend une première partie de forme d'onde de tension et une deuxième partie de forme d'onde de tension, et dans lequel la deuxième forme d'onde de tension comprend une troisième partie de forme d'onde de tension et une quatrième partie de forme d'onde de tension ;
   un processeur (103),
   **caractérisé en ce que** le processeur (103) est formé :

      une courbe de tension de référence sur la base d'une moyenne de tension à partir de la première courbe de tension et à partir de la seconde courbe de tension, la courbe de tension de référence comprenant une première partie de courbe de tension de référence et une seconde partie de courbe de tension de référence ;
      comparer la première courbe de tension à la courbe de tension de référence afin d'obtenir une première métrique indiquant un premier écart de tension entre la première partie de courbe de tension et la première partie de courbe de tension de référence et un deuxième écart de tension entre la deuxième partie de courbe de tension et la deuxième partie de courbe de tension de référence ;
      comparer la deuxième courbe de tension à la courbe de tension de référence pour obtenir une deuxième métrique indiquant un troisième écart de tension entre la troisième partie de courbe de tension et la première partie de courbe de tension de référence, et un quatrième écart de tension entre la quatrième partie de courbe de tension et la deuxième partie de courbe de tension de référence ;
      attribuer une première caractéristique électrique à la première partie de la courbe de tension et attribuer une deuxième caractéristique électrique à la deuxième partie de la courbe de tension si la première métrique est supérieure à la deuxième métrique, afin de classer le module de batterie par la première caractéristique électrique et la deuxième caractéristique électrique ; ou
      d'attribuer une troisième caractéristique électrique à la troisième partie d'évolution de tension et d'attribuer une quatrième caractéristique électrique à la quatrième partie d'évolution de tension si la première métrique est inférieure à la deuxième métrique, afin de classer le module de batterie par la troisième caractéristique électrique et la quatrième caractéristique électrique.

2. Système de gestion de batterie (100) selon la revendication 1, comprenant une mémoire (105) adaptée pour stocker une pluralité de caractéristiques électriques, dans lequel le processeur (103) est adapté pour lire la caractéristique électrique respective à partir de la mémoire (105).

3. Système de gestion de batterie (100) selon l'une quelconque des revendications précédentes, dans lequel le processeur (103) est adapté pour déterminer la courbe de tension de référence sur la base de la première courbe de tension et de la deuxième courbe de tension.

4. Système de gestion de batterie (100) selon la revendication 3, dans lequel la courbe de tension de référence comprend une médiane ou une moyenne de la première courbe de tension et de la deuxième courbe de tension.

5. Système de gestion de batterie (100) selon l'une quelconque des revendications précédentes, dans lequel le module de batterie comprend un troisième élément de batterie et l'interface est adaptée pour obtenir une troisième courbe de tension aux bornes du troisième élément de batterie, le processeur (103) étant adapté pour déterminer la courbe de tension de référence sur la base de la première courbe de tension, de la deuxième courbe de tension et de la troisième courbe de tension.

6. Système de gestion de batterie (100) selon la revendication 5, dans lequel la courbe de tension de référence comprend une médiane, une moyenne ou un mode de la première courbe de tension, de la deuxième courbe de tension et de la troisième courbe de tension.

7. Système de gestion de batterie (100) selon l'une quelconque des revendications précédentes, dans lequel le processeur (103) est formé :

déterminer la première caractéristique électrique sur la base de la première partie de la courbe de tension de la première courbe de tension et la deuxième caractéristique électrique sur la base de la deuxième partie de la courbe de tension de la première courbe de tension au moyen d'une analyse en composantes principales, la première caractéristique électrique représentant la première partie de la courbe de tension de la première courbe de tension et la deuxième caractéristique électrique représentant la deuxième partie de la courbe de tension de la première courbe de tension, et/ou
la troisième caractéristique électrique sur la base de la troisième partie de la courbe de tension de la deuxième courbe de tension et la quatrième caractéristique électrique sur la base de la quatrième partie de la courbe de tension de la deuxième courbe de tension au moyen de l'analyse en composantes principales, la troisième caractéristique électrique représentant la troisième partie de la courbe de tension de la deuxième courbe de tension et la quatrième caractéristique électrique représentant la quatrième partie de la courbe de tension de la deuxième courbe de tension.

8. Système de gestion de batterie (100) selon l'une quelconque des revendications précédentes, dans lequel le processeur (103) est adapté pour déterminer une première caractéristique électrique sur la base de la première partie d'allure de tension de la première allure de tension, une deuxième caractéristique électrique sur la base de la deuxième partie d'allure de tension de la première allure de tension, une troisième caractéristique électrique sur la base de la troisième partie d'allure de tension de la deuxième allure de tension, une quatrième caractéristique électrique sur la base de la quatrième partie d'allure de tension de la deuxième allure de tension.

9. Système de gestion de batterie (100) selon la revendication 8, dans lequel la première caractéristique électrique correspond à une tension de décalage du premier élément de batterie et la troisième caractéristique électrique correspond à une autre tension de décalage du deuxième élément de batterie, dans lequel la deuxième caractéristique électrique correspond à une résistance interne du premier élément de batterie et la quatrième caractéristique électrique correspond à une autre résistance interne du deuxième élément de batterie.

10. Système de gestion de batterie (100) selon l'une quelconque des revendications précédentes, dans lequel le processeur (103) est adapté pour classer le module de batterie au moyen d'un algorithme de classification, l'algorithme de classification comprenant au moins un élément parmi la régression logistique, la machine vectorielle de support, la forêt aléatoire, le perceptron multicouche et la machine vectorielle de support à classe unique.

11. Système de gestion de batterie (100) selon l'une quelconque des revendications précédentes, dans lequel l'interface (101) est adaptée pour obtenir une première pluralité de courbes de tension et une seconde pluralité de courbes de tension, chacune de la première pluralité de courbes de tension correspondant à un premier élément de batterie d'un module d'une pluralité de modules de batterie et chacune de la seconde pluralité de courbes de tension correspondant à un second élément de batterie d'un module de la pluralité de modules de batterie, l'interface étant adaptée pour gérer la pluralité de modules de batterie comme étant sans défaut,
dans lequel le processeur (103) est adapté pour classer chaque module de batterie de la pluralité de modules de batterie afin de former un groupe de référence sur la base de la classification.

12. Système de gestion de batterie (100) selon la revendication 11, dans lequel le processeur (103) est adapté pour classer la pluralité de modules de batterie au moyen d'un algorithme de classification supplémentaire, l'algorithme de classification supplémentaire comprenant au moins l'un parmi une régression logistique, une machine vectorielle de support, une forêt aléatoire, un perceptron multicouche et une machine vectorielle de support à classe unique.

13. Système de gestion de batterie (100) selon l'une quelconque des revendications précédentes, dans lequel la première courbe de tension comprend une cinquième partie de courbe de tension et la deuxième courbe de tension comprend une sixième partie de courbe de tension, dans lequel le processeur (103) est adapté pour extraire une cinquième caractéristique sur la base de la cinquième partie de courbe de tension de la première courbe de tension et une sixième caractéristique sur la base de la sixième partie de courbe de tension de la deuxième courbe de tension.

**14.** Système de gestion de batterie (100) selon la revendication 13, dans lequel la cinquième caractéristique correspond à une capacité du premier élément de batterie et la sixième caractéristique correspond à une autre capacité du deuxième élément de batterie.

**15.** Système de gestion de batterie (100) selon l'une quelconque des revendications précédentes, dans lequel l'interface (101) est adaptée pour obtenir un nombre de groupes à générer, une première pluralité supplémentaire de courbes de tension et une deuxième pluralité supplémentaire de courbes de tension, dans lequel chacune de la première pluralité supplémentaire de courbes de tension correspond à un premier élément de batterie d'un module d'une pluralité supplémentaire de modules de batterie et dans lequel chacune de la deuxième pluralité supplémentaire de courbes de tension correspond à un deuxième élément de batterie d'un module de la pluralité supplémentaire de modules de batterie,
dans lequel le processeur (103) est adapté pour associer chaque module de batterie de l'autre pluralité de modules de batterie à une pluralité de groupes au moyen de l'algorithme de classification, la quantité de la pluralité de groupes étant égale au nombre de groupes à générer.

**16.** Procédé (1200) de gestion de batterie, le procédé (1200) comprenant l'étape consistant à :

l'obtention (1201) d'une première courbe de tension aux bornes d'un premier élément de batterie d'un module de batterie et d'une deuxième courbe de tension aux bornes d'un deuxième élément de batterie du module de batterie, la première courbe de tension comprenant une première partie de courbe de tension et une deuxième partie de courbe de tension, et la deuxième courbe de tension comprenant une troisième partie de courbe de tension et une quatrième partie de courbe de tension ;
**caractérisé en ce que** le procédé comprend en outre les étapes consistant à :

déterminer (1203) une forme d'onde de tension de référence sur la base d'une moyenne de tension à partir de la première forme d'onde de tension et de la seconde forme d'onde de tension, la forme d'onde de tension de référence comprenant une première partie de forme d'onde de tension de référence et une seconde partie de forme d'onde de tension de référence ;
comparer (1205) la première courbe de tension à la courbe de tension de référence pour obtenir une première métrique indiquant un premier écart de tension entre la première partie de courbe de tension et la première partie de courbe de tension de référence et un deuxième écart de tension entre la deuxième partie de courbe de tension et la deuxième partie de courbe de tension de référence ;
comparer (1207) la deuxième courbe de tension à la courbe de tension de référence pour obtenir une deuxième métrique indiquant un troisième écart de tension entre la troisième partie de courbe de tension et la première partie de courbe de tension de référence, et un quatrième écart de tension entre la quatrième partie de courbe de tension et la deuxième partie de courbe de tension de référence ;
l'attribution (1209) d'une première caractéristique électrique à la première partie de variation de tension et d'une seconde caractéristique électrique à la seconde partie de variation de tension si la première métrique est supérieure à la seconde métrique, afin de classer le module de batterie par la première caractéristique électrique et la seconde caractéristique électrique ; ou
l'attribution (1211) d'une troisième caractéristique électrique à la troisième partie de variation de tension et d'une quatrième caractéristique électrique à la quatrième partie de variation de tension si la première métrique est inférieure à la deuxième métrique, afin de classer le module de batterie par la troisième caractéristique électrique et la quatrième caractéristique électrique.

100

Batteriemanagementsystem

Schnittstelle — 101

Prozessor — 103

Speicher — 105

Fig. 1

200

| Fall | Offset-Spannung | Kapazität | Innenwiderstand |
|---|---|---|---|
| 1 | x | x | x |
| 2 | x | x | ✓ |
| 3 | x | ✓ | x |
| 4 | x | ✓ | ✓ |
| 5 | ✓ | x | x |
| 6 | ✓ | x | ✓ |
| 7 | ✓ | ✓ | x |
| 8 | ✓ | ✓ | ✓ |

✓ Wert in Ordnung
x Wert nicht in Ordnung

Fig. 2

EP 4 196 805 B1

Fig. 3

400

403

Interpolationsbereich

Triggerpunkt

401

Fig. 4

500

Fig. 5

FIG. 6

Fig. 7

800

Fig. 8

EP 4 196 805 B1

900

Fig. 9

30

Fig. 10

1000

|  | Logistische Regression | Support Vector Machine | Random Forest | Mehr-schichtiges Perzeptron |
|---|---|---|---|---|
| Genauigkeit | 99,49 % | 100 % | 100 % | 100 % |
| Gesamtgenauigkeit | 98,99 % | 99,24 % | 99,24 % | 99,24 % |
| Dauer | 0,071 s | 0,026 s | 3,817 s | 0,809 s |

Fig. 11

1200

| Erhalten | 1201 |

| Bestimmen | 1203 |

| Vergleichen | 1205 |

| Vergleichen | 1207 |

| Zuordnen | 1209 |

| Zuordnen | 1211 |

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2016169978 A1
- US 6526361 B1